(19) Europäisches Patentamt
European Patent Office
Office européen des brevets

(11) Publication number : **0 554 051 A1**

(12) **EUROPEAN PATENT APPLICATION**

(21) Application number : **93300558.9**

(51) Int. Cl.$^5$ : **G09G 3/36,** H01L 21/76

(22) Date of filing : **27.01.93**

(30) Priority : **31.01.92 JP 40583/92**
**31.01.92 JP 40585/92**
**31.01.92 JP 41952/92**

(43) Date of publication of application :
**04.08.93 Bulletin 93/31**

(84) Designated Contracting States :
**DE FR GB**

(71) Applicant : **CANON KABUSHIKI KAISHA**
**30-2, 3-chome, Shimomaruko, Ohta-ku**
**Tokyo (JP)**

(72) Inventor : **Sakurai, Katsuhito, c/o Canon Kabushiki Kaisha**
**3-30-2, Shimomaruko, Ohta-ku**
**Tokyo (JP)**
Inventor : **Ishizaki, Akira, c/o Canon Kabushiki Kaisha**
**3-30-2, Shimomaruko, Ohta-ku**
**Tokyo (JP)**

(74) Representative : **Beresford, Keith Denis Lewis et al**
**BERESFORD & Co. 2-5 Warwick Court High Holborn**
**London WC1R 5DJ (GB)**

(54) **Image display device with single crystal silicon layer and methods of producing and driving the same.**

(57) An image display device which permits an increase in the resolution and which can be applied to a display panel having many pixels is provided by a matrix type image display device having a sampling transistor in a sampling circuit which is formed by a silicon single crystal. The silicon single crystal sampling transistor can decrease the sampling time constant and can sample and hold image signals even if the sampling time is less than the time corresponding to one pixel. The image display device also permits speeding up the driving circuit and is capable of displaying a clear image even when applied to an image having high resolution and a large image plane.

FIG. 7(e)

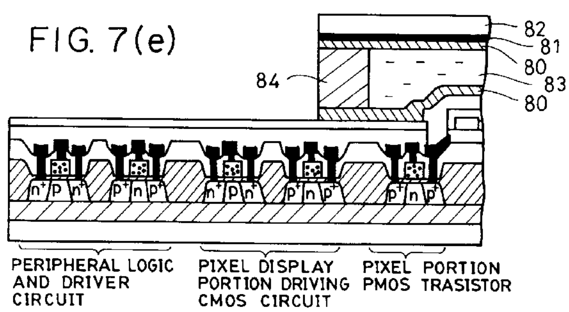


EP 0 554 051 A1

## BACKGROUND OF THE INVENTION

### Field of the Invention

The present invention relates to an image display device, as well as methods of producing and of driving the device. Particularly, the present invention relates to an image display device which has a semiconductor circuit and a display portion, which are formed on a single crystal substrate, which enables an increase in the resolution and an increase in the number of pixels, and which can use as the display portion, for example, an active matrix liquid crystal display portion, as well as a method of producing the device and a method of driving the device.

### Description of the Related Art

Development of various matrix type plane displays has been assisted by the decrease in size and width of circuit component portions of word processors, personal computers and the like due to the advances in semiconductor integration technique. Since a liquid crystal display device has an advantage with respect to a low voltage, low power consumption and the like and is suitable for an integrated circuit, the liquid crystal display device also attracts attention. Examples of matrix type liquid crystal display devices used for television sets and the like include both simple and active matrix type display devices. In the active matrix type display device, a pixel switch is provided for each pixel in order to cut off irrelevant signals during the time it is not selected so as to prevent the crosstalk between scanning lines, which is caused in the simple matrix type display device. Fig. 1 shows a typical example of the circuits of conventional matrix display portions in liquid crystal display devices as an example of such matrix type image display devices.

In the drawing, reference numerals 191 and 192 each denote a data sampling circuit, and reference numeral 190 denotes a vertical scanning timing signal generating circuit, which distributes the output of the data sampling circuit 192 to the pixels of the matrix display portion 196. Reference numeral 193 denotes a pixel selecting transistor disposed on each of the pixels of the matrix, and reference numeral 194 denotes a capacitor inserted for assisting the pixel capacity, and reference numeral 195 denotes the liquid crystal of each of the pixels.

A circuit comprising a shift register has been employed for each of the data sampling circuits 191 and 192. Fig. 2 shows an example of the conventional circuits and an example of data sampling pulses.

In Fig. 2, reference numeral 14 denotes delay flip flops provided in a column for each of data lines. In this example, the pulse width of an input timing data 11 is matched with the period of a clock 10. In this case, all data sampling pulses output to terminals 16, 17 and 18 have a pulse width which is equal to the sampling period, as shown by reference numeral 19 in Fig. 2. The rising and falling of each of the pulses are in time contact with the falling and rising of pulses before and after the concerned pulse. Reference numeral 15 denotes a switch comprising a transistor or the like. The switch 15 supplies an input image signal 12 maintained in an ON state, i.e., a short-circuit state, to the sample and hold circuit in the subsequent stage only during application of a pulse. At this time, since the ON resistance of the sampling transistor (switch) of each of the sampling circuits 191 and 192 is high, the sampling time constant becomes greater than the sampling period. Therefore, data cannot be sampled correctly by a sufficiently small sampling gate pulse. A method is generally employed to correct this problem in which the sampling time is set to be longer than the sampling period corresponding to a single pixel in the horizontal direction.

Fig. 3 shows an example of data sampling pulses applied to the circuit shown in Fig. 1 in which reference numbers used previously represent the same features.

The thin film transistor which constitutes the sampling switch 15 is conventionally a thin film transistor formed on a semiconductor on insulator ("SOI") substrate and having polysilicon or amorphous silicon channels and metal wiring for electrically connecting the channels. Since polysilicon or amorphous silicon is used for the channels, the mobility of electrons through the channels varies widely from 0.1 to 100 $cm^2/vs$.

The mobility of electrons limits the number of pixels because it determines the switching speed and the current driving force of the transistor. Namely, since the transistor for driving a signal line has insufficient speed and current driving force, the number of pixels on a single line is at most about 300 (90,000 pixels in the XY directions), and more integration cannot be made.

In addition, peripheral driving circuits such as a liquid crystal signal processing circuit and a signal generation circuit for driving the transistor are also required to have a high speed and high driving force. However, due to the limited available space, these circuits cannot be formed by a transistor using polysilicon or amorphous silicon because their large size. Rather, it is generally necessary to form the Se peripheral circuits in another chip of single crystal silicon in which the circuits are integrated.

Further, since the sampling transistor of the conventional sampling circuit does not have sufficient current driving force (and thus has a large resistance value in the ON state) as described above, the sampling time constant becomes greater than the sampling period, and data cannot be correctly sampled by a sampling gate pulse having a small width. To correct this the sampling pulse width is generally increased to a value greater than the sampling period in order to increase the ON time of the sampling transistor to a value greater than than the sampling time constant determined by the wiring resistance and the wiring capacity of data wiring and the ON resistance of the sampling transistor, as shown by reference numeral 19 in Fig. 3.

However, the above method has the problem that moire occurs in a signal having a frequency higher than the sampling frequency and thus causes sampling error. Additionally, integration is made with skipping a signal having a frequency higher than the reciprocal of the sampling time constant, thereby causing a decrease in the resolution.

Fig. 4 shows another example of the basic driving circuits of active matrix liquid crystal display devices.

In Fig. 4, reference numeral 401 denotes a horizontal shift register; reference numeral 402, a vertical shift register; reference numeral 403, a sampling MOS transistor; reference numeral 404, TFT (thin film transistor); and reference numeral 405, a liquid crystal cell. Reference numerals 406 to 408 denote three-line video input.

To the three-line video input 406 to 408 are input image signals obtained by cyclically rearranging the connection order of R, G, B primary color signals with a horizontal period in accordance with the horizontal arrangement of the color filters of a liquid crystal color matrix panel.

The horizontal lines are successively selected by the vertical shift register 402, and the video signals input to the three-line video input 406 to 408 are sampled by the horizontal shift register 401 and the sampling MOS transistors 403 and are successively written in the liquid crystal cells in the selected line.

However, this configuration sometimes has the following problems in that the writing time for a single pixel is significantly decreased as the fineness of a liquid crystal panel and the number of pixels thereof are increased. For example, if each horizontal line has 500 pixels, the writing time for each pixel is only 100 nsec because the effective scanning period of a horizontal scanning period is 63.5 $\mu$sec of NTSC with a horizontal blanking period is about 50 $\mu$sec.

In addition, the number of pixels and the opening rate cannot be increased because the resistance value in the ON state cannot be lowered due to the limited size of the TFT 404.

In the active matrix system, since data is written through the TFT in each pixel, the writing time is determined by the time constant which depends upon the the TFT resistance in the ON state and the capacity of the liquid crystal cells, and the above writing time cannot be easily satisfied.

## SUMMARY OF THE INVENTION

The present invention has been achieved in consideration of the above problems.

An object of the present invention is to provide an image display device, a method of driving the display device and a method of producing the display device which inhibits the occurrence of moire and which achieve the more faithful reproduction of an image of high quality.

Another object of the present invention is to provide an image display device, a method of driving the display device and a method of producing a display device which has a small sampling time constant, which enables the high-speed processing of a driving circuit, which enables the formation of a high-resolution image panel having a large number of pixels and a large image plane, and which is capable of displaying a clear image.

A further object of the present invention is to provide an image display device, a method of driving the display device and a method of driving the display device which permits a reduction in the chip size of a semiconductor element and to decrease the total cost of the display device.

In accordance with an aspect of the present invention, there is provided a method of producing an image display device comprising a semiconductor circuit having a sampling circuit for successively sampling analog image signals for each data line of a matrix and a circuit for supplying image signals to each of pixels on the basis of the sampled data; and display means for displaying an image on the basis of the image signals. The production method comprises the steps of forming a single crystal Si layer in which the semiconductor circuit is formed by the steps of the forming single crystal Si on a porous Si substrate, bonding the single crystal Si on a light transmitting substrate (or a Si substrate) through an insulating layer, and removing the porous Si substrate; and forming at least a portion of the element which constitutes the semiconductor circuit by employing the single crystal Si layer formed.

In accordance with another aspect of the present invention, there is provided a matrix type image display device for displaying an image by successively sampling analog image signals by a sampling circuit for each data line of a matrix and distributing the sampled data to the corresponding pixels. The sampling transistor in the sampling circuit is formed by using a single crystal.

In accordance with a further aspect of the present invention, there is provided an image display device comprising sample and hold means for sampling and holding the primary color signals which are cyclically rearranged with a horizontal scanning period in synchronism with a horizontal shift register so that the held signals are transmitted to each of the pixels on the line selected by a vertical shift register. The sample and hold means has switch means using as a control signal the signal of the horizontal register, and a buffer capacity, at least the switch means and the buffer capacity being provided on a single crystal silicon layer formed on a surface of a light transmitting substrate.

In accordance with a still further aspect of the present invention, there is provided an image display device comprising sample and hold means for alternately sampling and holding the primary color signals and the inverted signals thereof, which are cyclically rearranged with a horizontal scanning period, with the horizontal scanning period or a pixel period in synchronism with a horizontal shift register so that the held signals are transmitted to each of the pixels on the line selected by a vertical shift register. The sample and hold means has switch means using as a control signal the signal of the horizontal shift register and a buffer capacity, at least the switch means and the buffer capacity being provided on the single crystal silicon layer formed on a surface of a light transmitting substrate.

In accordance with a further aspect of the present invention, there is provided a method of driving a matrix type image display device for displaying an image by successively sampling analog image signals for each data line of a matrix and then distributing the sampled signals to the pixels, wherein a low pass filter having a time constant greater than the sampling time is inserted into a image signal line.

In accordance with a further aspect of the present invention, there is provided a method of driving a matrix type image display for displaying an image by successively sampling analog image signals for each data line of a matrix and then distributing the sampled signals to the pixels, wherein integration means is inserted into a image signal line.

## BRIEF DESCRIPTION OF THE DRAWINGS

Fig. 1 is a drawing showing conventional matrix display portion circuits;

Fig. 2 is a drawing showing a conventional data sampling circuit;

Fig. 3 is a drawing showing a conventional data sampling circuit;

Fig. 4 is a drawing showing a conventional active matrix type liquid crystal display driving circuit;

Fig. 5 is a drawing showing the dependency of the thickness of porous and single crystal Si etched layer on the etching time;

Fig. 6(a) to 6(c) are schematic sectional views illustrating the steps of producing a SOI substrate for use in the present invention;

Figs. 7(a) to 7(d) are schematic sectional views showing the method of producing a semiconductor device in accordance with the present invention, Fig. 7(e) is a schematic sectional view showing a liquid crystal display having the semiconductor device shown in Fig. 7(d), and Fig. 7(f) is a schematic sectional view showing each of the portions of the liquid crystal display shown in Fig. 7(e);

Figs. 8, 12, 14, 18 and 20 are schematic drawings of circuits respectively illustrating examples of the data sampling circuit used in the present invention;

Figs. 9, 11, 13, 15, 16, 19 and 21 are drawings illustrating examples of data sampling pulses;

Figs. 10(a) and 10(b) and 17 are drawings respectively illustrating examples of the equivalent circuit of a data sampling circuit and a time chart for data sampling;

Fig. 22 is a drawing showing the driving circuit of an active matrix liquid crystal display device according to Embodiment 9 of the present invention;

Fig. 23 is a drawing showing the circuit of the portion surrounded by a one-dot chain line in Fig. 22;

Fig. 24 is a time chart of the circuit portion shown in Fig. 23;

Fig. 25 is a sectional view showing the structure of the circuit component shown in Fig. 23;

Fig. 26 is a drawing showing a portion of the driving circuit of an active matrix liquid crystal display device according to Embodiment 10;

Fig. 27 is a time chart of the circuit portion shown in Fig. 26;

Fig. 28 is a drawing showing a portion of the driving circuit of an active matrix liquid crystal display device according to Embodiment 11;

Fig. 29 is a timing chart for writing with opposite polarities in the vertical direction; and

Fig. 30 is a timing chart for writing with opposite polarities in the horizontal direction.

## DESCRIPTION OF THE PREFERRED EMBODIMENTS

Since a preferred example of the present invention uses a Si semiconductor substrate in which a single crystal Si layer is formed on an insulating base material by using porous Si, the porous Si substrate is first described below.

The porous Si substrate has pores having an average size of about 600 Å which is determined by observation using a transmission electron microscope. Although the density of the porous Si substrate is less than half that of single crystal Si, the single crystallinity is maintained, and a single crystal Si layer can be formed on the porous layer by epitaxial growth. However, at a temperature of 1000°C or more, the internal pores are rearranged, and the etching properties deteriorate when the etching speed is increased. It is preferable for epitaxial growth of the Si layer to use a low-temperature growth method such as a molecular beam epitaxial growth method, a plasma CVD method, a thermal CVD method, an optical CVD method, a bias sputtering method, a liquid crystal growth method or the like.

A method of epitaxially growing a single crystal layer after p-type Si is made porous is described below. A Si single crystal substrate is prepared and made porous by anodization using an HF solution. Although the density of single crystal Si is 2.33 g/cm$^3$, the density of the porous Si substrate can be changed to 0.6 to 1.1 g/cm$^3$ by changing the concentration of the HF solution to 20 to 50 % by weight. The porous layer is easily formed into a p-type Si substrate for the reasons below.

Porous Si was discovered by Uhlir et al. in the course of research on electropolishing of a semiconductor in 1956 (A. Uhlir, Bell Syst. Tech. J., vol. 35, p. 333 (1965)). Unagami et al. investigated Si dissolution reaction in anodization and reported that the Si anodization in an HF solution requires holes and proceeds in accordance with the following reaction formulas (T. Unagami: J. Electrochem. Soc., vol. 127, p. 476 (1980)):

$$Si + 2HF + (2 - n)\ e^+ \rightarrow SiF_2 + 2H^+ + ne^-$$
$$SiF_2 + 2HF \rightarrow SiF_4 + H_2$$
$$SiF_4 + 2HF \rightarrow H_2SiF_6$$

or

$$Si + 4HF + (4 - \lambda)\ e^+ \rightarrow SiF_4 + 4H^+ + \lambda e^-$$
$$SiF_4 + 2HF \rightarrow H_2SiF_6$$

wherein e+ and e- indicate a hole and an electron, respectively, n and $\lambda$ each indicate the number of holes required for dissolving one Si atom. It was also reported that when the conditions of $n > 2$ and $\lambda > 4$ are satisfied, porous Si is formed.

On the other hand, it has been reported that high-density n-type Si also can be made porous (R. P. Holmstorm, I. J. Y. Chi. Appl. Phys. Lett., Vol. 422, 386 (1983)). Both p-type and n-type Si can thus be made porous.

In addition, since the porous layer contains the large void formed therein, the density is reduced by at least half. As a result, the surface area is significantly increased, as compared with the volume thereof, and the chemical etching speed is thus significantly increased, as compared with the etching speed of a usual single crystal layer.

The conditions for making single crystal Si porous by anodization are described below. The starting material of the porous Si formed by anodization is not limited to single crystal Si, and Si having other crystal structures can be used.

Applied voltage: 2.6 (V)
Current density: 30 (mA·cm$^{-2}$)
Anodization solution: HF : $H_2O$ : $C_2H_5OH$ = 1 : 1 : 1
Time: 2.4 (hr)
Thickness of porous Si: 300 (μm)
Porosity: 56 (%)

Si is deposited on the thus-formed porous Si substrate by epitaxial growth to form a single crystal Si thin film. The thickness of the single crystal Si thin film is preferably 50 μm or less, more preferably 20 μm or less.

After the surface of the single crystal Si thin film is oxidized, a substrate which finally forms a substrate is prepared and bonded to the oxide film on the surface of the single crystal Si. Alternatively, after the surface of a new single crystal Si substrate is oxidized, the new substrate is bonded to the single crystal Si layer on the porous Si substrate. The reason for providing the oxide film between the substrate and the single crystal Si layer is described below.

For example, when a glass substrate is used, since the surface potential generated at the boundary between the Si active layer and the oxide film can be decreased, as compared with the boundary between the Si active layer and the glass substrate, the characteristics of an electron device can be significantly improved. In addition, only the single crystal Si thin film obtained by removing the porous Si substrate by the selective etching described below may be bonded to a new substrate. After washing, the substrate can be sufficiently bonded to the single crystal Si thin film using van der Waals force by simply bringing the both surfaces into contact with each other. Both substrates are then completely bonded by further heat treatment in an atmosphere of nitrogen at 200 to 900°C, preferably 600 to 900°C.

An $Si_3N_4$ layer is then deposited as an anti-etching film over the whole surface of the two substrates bonded, and only the portion of the $Si_3N_4$ layer on the surface of the porous Si substrate is removed. Apiezon wax may be used in place of the $Si_3N_4$ layer. The porous Si substrate is then completely removed by etching or the like to obtain a semiconductor substrate having the thin film single crystal Si layer.

The selective etching method for electroless wet etching of the porous Si substrate is described below.

Preferred examples of etching solutions which do not etch crystal Si but which can selectively etch porous Si include hydrofluoric acid, buffered hydrofluoric acid such as ammonium fluoride ($NH_4F$), hydrogen fluoride (HF) and the like, a mixture of hydrogen peroxide and hydrofluoric acid or buffered hydrofluoric acid, a mixture of an alcohol and hydrofluoric acid or buffered hydrofluoric acid, and a mixture of hydrogen peroxide, an alcohol and hydrofluoric acid or buffered hydrofluoric acid. The etching is effected by wetting the bonded substrates with the etching solution. The etching speed depends upon the concentration and temperature of hydrofluoric acid, buffered hydrofluoric acid or hydrogen peroxide. The speed of Si oxidation can be increased by adding a hydrogen peroxide solution serving as an oxidizer, as compared with etching without the hydrogen peroxide solution. The reaction speed can also be controlled by changing the ratio of the hydrogen peroxide solution added. In addition, the addition of an alcohol permits the bubbles of the gases produced by the etching reaction to be instantaneously removed from the etched surface without agitation, and thus permits efficient and uniform etching of porous Si.

The HF concentration in the buffered hydrofluoric acid is preferably set within the range of 1 to 95 % by weight, more preferably 1 to 85 % by weight, and most preferably 1 to 70 % by weight, based on the etching solution. The $NH_4F$ concentration in the buffered hydrofluoric acid is preferably set within the range of 1 to 95 % by weight, more preferably 5 to 90 % by weight, and most preferably 5 to 80 % by weight, based on the etching solution.

The HF concentration in the hydrofluoric acid solution is preferably set within the range of 1 to 95 % by weight, more preferably 5 to 90 % by weight, and most preferably 5 to 80 % by weight, based on the etching solution.

The $H_2O_2$ concentration is preferably set within the range of 1 to 95 % by weight, more preferably 5 to 90 % by weight, and most preferably 10 to 80 % by weight, based on the etching solution, and within the range which allows the hydrogen peroxide to exhibit the effect.

Any alcohols such as ethyl alcohol, isoproply alcohol and the like, which have no practical difficulty and from which the usual effect of adding an alcohol can be expected can be used in the etching step. The alcohol concentration is preferably set to be 80 % by weight or less, more preferably 60 % by weight or less, and most preferably 40 % by weight or less, based on the etching solution, and within the range which allows the alcohol to exhibit the effect.

The temperature is preferably set within the range of 0 to 100°C, more preferably 5 to 80°C, and most preferably 5 to 60°C.

The semiconductor substrate formed by the above process has the flat single crystal Si layer which is uniformly thinned and formed over the large area of the substrate, like usual Si wafers. The single crystal Si layer of the semiconductor substrate is then separated into portions by partial oxidation or etching in an island-like form and doped with impurities to form p- or n-channel transistors.

The selectivity for making the Si substrate porous is verified by Nagano et al. and Imai (Nagano, Nakajima, Ohnaka, Kajiwara; the technical report of Institute of Electronics and Communication Engineers of Japan, vol. 79, SSD 79-9549 (1979), K. Imai; Solid-State Electronics vol. 24, 159 (1981)). As described above, p-type and n-type silicon having holes can both be made porous easily and selectively.

It is thus important to select a substrate which can be actually made porous regardless of the p- or n-type.

In addition, the porous Si layer has pores having an average size of about 600 Å which is determined by observation on a transmission electron microscope. Although the density of the porous Si layer is about half of that of single crystal Si, the single crystallinity is maintained.

Known methods of etching porous Si are the following:

(1) a method of etching porous Si by an aqueous NaOH solution (G. Bonchil, R. Herino, K. Barla, and J. C. Pfister, J. Electrohcem. Soc., vol. 130, No. 7, 1611 (1983)): and

(2) a method of etching porous Si by the above etching solution which can etch single crystal Si.

The above method (2) generally uses a fluoronitric acid etching solution, as described above. The Si etching step is further described in detail below. The etching reaction proceeds as following:

$$Si + 2O \rightarrow SiO_2$$

$$SiO_2 + 4HF \rightarrow SiF_4 + H_2O$$

Namely, Si is oxidized to $SiO_2$ by nitric acid, and etching of Si proceeds as $SiO_2$ is etched by hydrofluoric acid.

Examples of etching solutions other than the fluoronitric acid etching solution used for etching crystal Si include the following:

ethylenediamine type
KOH type
hydrazine type

Fig. 5 shows the dependency on the etching time of the thickness of porous Si and nonporous single crystal Si which were etched by wetting with a mixture containing hydrofluoric acid, an alcohol and hydrogen peroxide without agitation.

The dependency is further described below with reference to Figs. 6(a) to 6(c).

A single crystal Si layer 2 having a thickness of about 1 μm was formed, by the CVD process, on the porous Si substrate 1 formed under the above conditions (Fig. 6(a)).

As shown in Fig. 6(b), a light transmitting glass substrate 3 is prepared and is bonded to the surface of the single crystal Si layer 2 on the porous Si substrate 1. In the bonding step, both surfaces to be bonded are brought into close contact with each other and then heated at 900°C in an atmosphere of oxygen or nitrogen. Before the bonding step, an oxide layer 6 serving as an insulating layer may be formed on the surface of the nonporous single crystal Si layer 2. The oxide layer 6 is formed for decreasing the surface potential of the single crystal silicon layer 2 finally serving as an active layer.

If required, the whole surface of the two substrates bonded is covered with a $Si_3N_4$ layer serving as an anti-etching layer 5, and the $Si_3N_4$ layer on the porous surface of the porous silicon substrate 1 is removed. Apiezon wax may be used as the anti-etching layer 5 in place of the $Si_3N_4$ layer.

The bonded substrates are then wetted with a mixture containing 49%- hydrofluoric acid, an alcohol and hydrogen peroxide (10 : 6 : 50) (white dot) without agitation. As a result, the porous Si could be rapidly and uniformly etched. The etching speed depends upon the concentration of the etching solution and the temperature thereof.

In this way, the porous Si substrate 1 is completely etched, leaving the single crystal thin film thin layer 2 formed on the light transmitting glass 3.

Before the etching step, the rear side of the porous Si substrate 1 (porous layer) may be thinned by machining such as grinding, polishing or the like. Particularly, when the Si substrate is partially made porous, it is preferable to thin the Si substrate by machining until the porous layer 1 is exposed.

Fig. 6(c) shows the semiconductor substrate obtained in the present invention. Namely, the $Si_3N_4$ layer serving ass the anti-etching layer 5 and the porous layer 1 shown in Fig. 6(b) are removed to uniformly form the single crystal Si thin layer 2 having the same crystallinity as that of a silicon wafer over the whole area of the light transmitting glass substrate 3.

A description will now be made of an example of the method of producing a transistor. Of course, the production method and the transistor structure are not limited to those described below, and other structures and other production methods may also be employed.

Fig. 7(a) shows the semiconductor substrate obtained by the above method. In Fig. 7(a), reference numeral 71 denotes a glass substrate; reference numeral 72, an insulating layer; and reference numeral 73, a single crystal silicon layer. After a silicon oxide film of 200 to 1000 Å is formed on the semiconductor substrate by thermal oxidation, a silicon nitride film of 100 to 500 Å is formed by the LPCVD process, is patterned to a desired shape and is then subjected to selective oxidation (LOCOS) of silicon at 100°C for 1 to 6 hours. In this case, the portion 74 selectively oxidized may be extended to the lower insulating layer so as to be completely separated from the adjacent active portion, as shown in Fig. 7(b), or the single crystal silicon layer may be connected in the horizontal direction by forming a channel stop layer. P-type active portions and n-type active portions are then formed by photolithography and ion implantation, as shown in Fig. 7(b).

Polysilicon is then deposited to a thickness of 500 to 5000 Å by the LPCVD process. Since the polysilicon layer can be used as a material for MOSFET gate electrodes and as a wiring layer, the polysilicon layer is preferably as thick as possible in order to decrease the electrical resistance. Alternatively, a metal silicide (tungsten, titanium or the like) may be laminated on the polysilicon layer having a thickness of about 2000 Å in order to decrease the resistance.

The polysilicon layer is then patterned, and arsenic or phosphorus ions and boron or boron fluoride ions are implanted in the NMOS portions and PMOS portions, respectively, followed by heat treatment at 500 to 100°C to obtain the structure shown in Fig. 7(c). The structure shown in Fig. 7(c) is a single drain structure in which both the $n^+$ layer and $p^+$ layer in the NMOS and PMOS portions directly contact with the channel region. However, for example, $n^-$ and $p^-$ layers may be respectively formed between the $n^+$ and $p^+$ layers and the channel layer by an additional step so as to relieve the electrical field produced at the PN junction, thereby enabling the transistor to be driven at a higher voltage. The inventors also found from experiment that when a power voltage of 10 V or more is required, the above structure for relieving the electrical field is effective.

A BPSG film is then deposited to a thickness of 3000 to 8000 Å by the CVD process to form a first layer insulating layer 75. After contact holes are formed for leading out electrodes, an aluminum electrode is formed to a thickness of 3000 to 8000 Å by the sputtering method. After the aluminum electrode is patterned, a silicon nitride film or a silicon oxide film is deposited to a thickness of 3000 to 10000 Å by the plasma excitation or thermal CVD process. This silicon nitride or silicon oxide film serves as a second layer insulating layer 76. At this time, it is effective for the reasons below to flatten the semiconductor surface as much as possible by spinning the semiconductor substrate.

Flattening decreases the trouble of the second and higher wiring layers disconnecting, which is caused by a large difference in evenness when multilayer wiring is provided. Also, flattening causes uniform orientation treatment for orienting a liquid crystal and thus improves the quality of the matrix panel.

The subsequent steps are performed for forming a storage capacity of the display pixel portion, but not adding functions to the driving circuit portion, the peripheral logic circuit and the driver circuit portion However, the steps do not hinder the operation of MOSFET.

In other words, ITO (indium-tin oxide film) is deposited to a thickness of 500 to 2000 Å by the sputtering process in a gas mixture of argon and nitrogen to form a first transparent electrode 77. A silicon oxide film is then deposited to a thickness of 300 to 3000 Å by the sputtering process or the CVD process. This silicon oxide film serves as a film 78 for determining the storage capacity, and the thickness thereof is determined by the necessary gradation, the area of the storage capacity portion, the parasitic capacity on the electrode on the pixel side of the pixel transistor and so on.

For example, in order to ensure 64 gradation, the storage capacity is 120 pF, and the thickness of the silicon oxide film can be set to 2000 Å.

In the final step, contact holes are again formed, and ITO is deposited to a thickness of 500 to 2000 Å to form a second transparent electrode 79. Fig. 7(d) shows the structure obtained after sputtering. An orientation film 80 is then deposited and is subjected to orientation treatment, and a liquid crystal material 83 is then charged in the display portion. These steps are the same as those of a conventional method of forming a liquid crystal panel.

Fig. 7(e) shows an example of the liquid crystal display device formed by the above method. In Fig. 7(e), reference numeral 80 denotes an orientation film; reference numeral 81 a counter electrode; reference numeral 82, a glass plate; reference numeral 83, a liquid crystal material; and reference numeral 84, a sealing material. The pixel portion transistor is provided in correspondence with each of the pixels. In the right portion of the liquid crystal display device not shown in Fig. 7(e), the pixel portion transistor and the storage capacity portion are repeatedly formed in the number of required pixels.

Fig. 7(f) is a schematic plan view of the liquid crystal display device formed. Fig. 7(e) is thus a schematic sectional view of the liquid crystal display device taken along line 7(e) - 7(e)' in Fig. 7(f) and shows the first transistor and storage capacity portion on the left side of the image display portion.

Although the transistor of the pixel portion shown in Fig. 7(d) comprises PMOS, NMOS can, of course, also be used for realizing the same function by the same process.

In the semiconductor device formed by the above method, the display pixel portion, the driving circuit therefor, the peripheral logic circuit and the driver circuit are formed on the same chip, as shown in Fig. 7(d). It is thus significantly decrease the total cost including packaging, and to form a very compact module. When the same circuit is realized by the polysilicon TFT technique which is generally used, the size of the whole chip is increased to about 10 times that of the chip of the present invention.

In accordance with the present invention, since the sampling transistor is made of a single crystal, the ON resistance and hold capacity of the sampling transistor, which determine the time constant thereof, can be decreased, and the sampling time constant can be decreased, thereby achieve the objects of the present invention.

Namely, in order to achieve the objects, a preferred embodiment of the present invention relates to a matrix type image display device for displaying an image by successively sampling serial analog image signals for each data line of the matrix and then distributing the sampled data to the pixels, in which the sampling transistor in the sampling circuit comprises a single crystal.

In the present invention, the sampling time constant is decreased so that the sampling transistor can follow a signal having high a frequency component even if the sampling time is decreased to less than the time obtained by dividing the one horizontal effective scanning time by the number of the pixels in the horizontal direction, thereby increasing the resolution The single crystal semiconductor used in the present invention is formed by using a porous substrate and is thus a high-quality semiconductor having substantially no defect. The single crystal thin film is formed by the above-described method.

In addition, in the present invention, a low pass filter (LPF) having a time constant greater than the sampling time or integration means is inserted into an image signal line so that the occurrence of moire can be inhibited by cutting off a component having a frequency higher than the sampling frequency, thereby achieving the objects.

Namely, in order to achieve the objects, another preferred embodiment of the present invention relates to a method of driving a matrix type image display device for displaying an image by successively sampling serial analog image signals for each data line of the matrix and then distributing the sampled data, wherein a low pass filter having a time constant greater than the sampling time or integration means is inserted into the image signal line. The image display comprises a semiconductor circuit required for performing the driving method and formed on a single crystal substrate.

In this arrangement, the semiconductor circuit is formed on the single crystal substrate because when the semiconductor circuit is formed by using polysilicon, amorphous silicon or the like, the ON resistance and hold capacity of the sampling transistor are increased, and thus the semiconductor circuit cannot be applied to a display panel having many pixels due to an increase in the sampling time constant.

As described above, the single crystal substrate used in the present invention is produced by using a porous substrate and is a high-quality single crystal semiconductor having substantially no defect.

In an active matrix liquid crystal display device, sample and hold means may be provided for enabling high-speed driving and enabling the application to a panel which has many pixels and high fineness and which requires high-speed driving. Namely, three-line video input signals may be once held in the sample and hold means and then collectively written in the selected pixels.

However, for example, in a panel having 230000 pixel NTSC non-interlace driving and a pixel size of 20 x 30 μm, when the display property in a 64-gradation level is considered for improving the image quality, a sample and hold capacity of about 10 pF is required for constituting the sample and hold means.

If the sample and hold capacity is formed by forming an insulating layer on the polysilicon layer and then providing polysilicon, the capacity width is about 0.2 mm, thereby increasing the size. If the thickness of the insulating film between the polysilicon layers is decreased for decreasing the size, the problems of decreasing the voltage resistance and increasing the leak current are produced.

Further, the video signals must be written in the sample and hold capacity at a speed of as high as 10 MHz, and the ON resistance of the switching transistor must be decreased for writing with such a frequency. With polysilicon TFT, the size must be increased to W/L = 4500 μm/2 μm. This increases the W value of a pattern and thus makes practical layout very difficult.

In order to achieve the objects, a further preferred embodiment of the present invention relates to the formation of the sample and hold capacity which constitutes the sample and hold means and the switching transistor in the single crystal Si layer by using the SOI technique which is capable of forming a single crystal Si layer having excellent crystallinity on a light transmitting substrate such as a glass substrate or the like. As in the present invention, when the sample and hold capacity is formed by using the single crystal Si material, a good oxide film can be formed, and the capacity having a width of 0.04 to 0.06 mm can be formed, thereby decreasing the chip size by 0.14 to 0.16 mm. In addition, the use of the single crystal Si-TFT technique permits the TFT size to be decreased to W/L = 70/2 to 90/2 (μm/μm). If layout is carried out, the chip size can thus be decreased by about 0.36 to 0.38 mm. The chip size is thus decreased by about 0.5 mm by both the capacity and TFT, thereby making an attempt to decrease the cost. Particularly, the present invention is more effective for application to a high quality liquid crystal image display device having high image quality.

In order to achieve the objects, the present invention provides an active matrix liquid crystal image display device comprising sample and hold means for cyclically sampling and holding the primary color signals rearranged in synchronism with a horizontal shift register with a horizontal scanning period so that the held signals are transmitted to each of the pixels on the line selected by a vertical shift register. The sample and hold means has switch means using as a control signal the signal of the horizontal shift register and a buffer capacity, at least the switch means and the buffer capacity being provided in the single crystal silicon layer formed on the surface of a light transmitting substrate.

In order to achieve the objects, the present invention provides an active matrix liquid crystal image display device comprising sample and hold means for cyclically sampling and holding the primary color signals rearranged and the reversed signals thereof in synchronism with a horizontal shift register with a horizontal scanning period or a pixel period so that the held signals are transmitted to each of the pixels in the line selected by a vertical shift register. The sample and hold means has switch means using as a control signal the signal of the horizontal shift register and a buffer capacity, at least the switch means and the buffer capacity being provided in the single crystal silicon layer formed on the surface of a light transmitting substrate.

The objects of the present invention can be effectively achieved by using the SOI substrate produced by a method comprising the steps of bonding the surface of the nonporous single crystal layer formed on a porous Si substrate or the surface of the insulating layer formed on the nonporous single crystal layer to a light transmitting substrate, and forming a single crystal semiconductor layer on the bonded light transmitting substrate or insulating layer by removing the porous first Si substrate by treatment including at least wet chemical etching.

The present invention is described in detail below with reference to embodiments.

(Embodiment 1)

Fig. 8 shows a data sampling circuit in accordance with a preferred embodiment of the present invention. The circuit comprises a shift register. In Fig. 8, reference numeral 10 denotes a transfer clock; reference numeral 11, input timing data; and reference numeral 14, a delay flip flop. The sampling transistor 15 of each of data lines comprises a Si single crystal, and a part of a control circuit for controlling the sampling transistor is denoted by reference numeral 16, 17 or 18.

Sampling is performed by the data sampling pulse shown in Fig. 9. In Fig. 9, $T_{(S/H)}$ shows the sampling period, $t_{(S/H)}$ shows the ON time, i.e., the sampling time, of the sampling transistor, and $t_{(pitch)}$ shows the time obtained by dividing the one horizontal effective scanning time by the number of pixels in the horizontal direction, i.e., the time corresponding to a single pixel in the horizontal direction.

Figs. 10(a) and (b) show a time chart for data sampling and a portion of the equivalent circuits of the data sampling circuit. In Figs. 10(a) and (b), if the sampling time constant $\tau_{(S/H)}$ determined by the ON resistance of the sampling transistor 15, the wiring resistance 31 of data wiring, the wiring capacity 32 and the hold capacity 33 is $\tau_{(S/H)} \leqq t_{(S/H)}$, the voltage 30 (voltage held by the hold capacity 33) reaches the voltage of the image signal 20 during the time of $t_{(S/H)}$, and then follows the high frequency component so that the voltage at point C of the image signal in the rising time $t_{(S/H)}$ is held. It is thus possible to respond to an image signal having a high frequency component.

In addition, if $t_{(pitch)} > t_{(S/H)}$, as shown in Fig. 9, the image signals in the period of each pixel can be sampled and held, thereby improving image resolution.

Since the blanking period in the one horizontal scanning period of 63.5 μsec is 10.8 μsec, the effective scanning period is 52.7 μsec. For example, if the resolution in the vertical direction is 490, and the aspect ratio is 4/3, the resolution in the horizontal direction is 652, and $t_{(pitch)}$ is as follows:

$$t_{(pitch)} = 52.7\ \mu sec/652 = 80\ nsec$$

When the sampling transistor 15 is formed by using polysilicon or amorphous silicon, as conventional methods, (ON resistance + wiring resistance) is 10 kΩ, (hold capacity + wiring capacity) is about 30 pF and the sampling time constant $\tau_{(S/H)}$ is as follows:

$$\tau_{(S/H)} = 10\ k\Omega \times 30\ pF = 300\ nsec$$

This time constant does not satisfy the condition, $\tau_{(S/H)} \leqq t_{(S/H)}$.

On the other hand, when the sampling transistor 15 is formed by using a single crystal, as in this embodiment, (ON resistance + wiring resistance) is 1 kΩ, (hold capacity (comprising MOS capacity) + wiring capacity) is about 10 pF and the sampling time constant $\tau_{(S/H)}$ is as follows:

$$\tau_{(S/H)} = 1\ k\Omega \times 10\ pF = 10\ nsec$$

This time constant is 1/30 of the conventional value. In this case, the frequency of a followable image signal is 100 KHz, and the condition, $\tau_{(S/H)} \leqq t_{(S/H)}$, can be sufficiently satisfied.

If $\tau_{(S/H)}$ is 50 nsec of less, it is possible to sufficiently apply to a display panel having at least 1000 pixels in the horizontal direction.

(Embodiment 2)

In this embodiment, the data sampling circuit shown in Fig. 8 comprising a sampling transistor 14 formed by using a single crystal is used, as in Embodiment 1, and the sampling waveform shown in Fig. 11 is employed.

If $\tau_{(S/H)}$ satisfies the condition, $\tau_{(S/H)} \leqq t_{(S/H)}$, and is small enough to follow the frequency of the image signal, as shown in Fig. 10(a), the voltage of the image signal sampled is determined by the rising of the each of the sampling pulses 16 to 18.

When the sampling timing is set so that the rising of each of the sampling pulses 16 to 18 is positioned at the center of the image signal corresponding to the each of the pixels, as shown in Fig. 11, the image in the central portion of the image signal can be reproduced.

In this way, any portion within the pitch of the pixels in the horizontal direction can be sampled.

(Embodiment 3)

Fig. 12 shows a color-correspondence data sampling circuit in accordance with an embodiment of the present invention. In the circuit, a sampling transistor 15 comprises a Si single crystal. Fig. 13 shows a sampling waveform.

To image signal lines 12 are input the signals obtained by cyclically rearranging R, G, B primary color signals with the horizontal period matched with the arrangement of the color filters of a color matrix panel in the horizontal direction thereof. The image signals 12 on three lines are successively sampled and held on the basis of the signals 50 to 53 output from the shift registers.

In this embodiment, since $t_{(pitch)} > t_{(S/H)}$, the falling of the sampling pulse is positioned within the period of each of the pixels, and color in each of the pixels can securely be sampled, thereby increasing the resolution of the color image signals.

(Embodiment 4)

Fig. 14 shows a data sampling circuit in accordance with another preferred embodiment of the present invention. The circuit is formed by using polysilicon or amorphous silicon and comprises a shift register. In Fig. 14, reference numeral 10 denotes a transfer clock; reference numeral 11, input timing data; reference numeral 12, an image signal line; reference numeral 13, a low pass filter (LPF); and reference numeral 14, delay flip flops. A part of a control circuit for controlling a sampling register 15 of each of data lines is denoted by reference numeral 16, 17 or 18.

The LPF 13 having a time constant $\tau_{(LPF)}$ which satisfies the equation 1 below is inserted into the image signal line 12. This causes the image signal to be integrated with the time constant $\tau_{(LPF)}$, and the frequency components having frequencies of $1/\tau_{(LPF)}$ or more to be cut off.

$$\tau_{(LPF)} > t_{(pitch)} \quad (1)$$

(wherein $t_{(pitch)}$ is a time obtained by dividing the one horizontal effective scanning time by the number of horizontal pixels, i.e., the time corresponding to one pixel in the horizontal direction).

Sampling is made so that the equation (2) below is satisfied, as shown in Fig. 15.

$$T_{(S/H)} = t_{(S/H)} = t_{(pitch)} \quad (2)$$

(wherein $T_{(S/H)}$ is a sampling period, and $t_{(S/H)}$ is the ON time of the sampling transistors, i.e., the sampling time).

In this case, the sampling time constant $\tau_{(S/H)}$ determined by the ON resistance of the sampling transistors, and the wiring resistance and the wiring capacity of the data wiring and the hold capacity must be set so as to satisfy the condition, $\tau_{(S/H)} < t_{(S/H)}$, as described above. This causes sampling and holding of the values obtained by integrating the image signals, for example, between the points a and b of the image signal waveform 20 shown in Fig. 15, and thus inhibits moire from occurring in the image signal due to the frequency component of $1/t_{(S/H)}$ or more. In addition, since the integrated value of the image signal level within a single pixel period is written, an image can be more faithfully reproduced. In Fig. 15, reference numeral 19 denotes the data sampling pulses.

(Embodiment 5)

This embodiment uses the data sampling circuit shown in Fig. 14 and formed by using polysilicon or amorphous silicon, as in Embodiment 4, and employs the sampling waveform shown in Fig. 16. Fig. 17 shows part of the equivalent circuits of the data sampling circuit and the time chart for data sampling.

In this embodiment, if the sampling time constant $\tau_{(S/H)}$ determined by the ON resistance 41 of a switch comprising a transistor or the like, the wiring resistance 42 and the wiring capacity 43 of data wiring and the hold capacity 44 satisfies the condition, $\tau_{(S/H)} < t_{(S/H)}$, a voltage 45 (voltage held by the hold capacity 44) matches with the image signal 20 within the period $t_{(S/H)}$, as shown in Fig. 17. High-frequency components of the image signal 20 are cut off by passing through the LPF, and the voltage at point C in falling of the image signal within the sampling time $t_{(S/H)}$ is then held.

In addition, since the high-frequency components of the image signal 20 are cut off, the position of the sampling pulse can be set at any position within a single pixel period, with satisfying the following relation:

$$T_{(S/H)} = t_{(pitch)} > t_{(S/H)} > \tau_{(S/H)}$$

Thus an image can faithfully be reproduced.

(Embodiment 6)

Fig. 18 shows a color correspondence data sampling circuit in accordance with an embodiment of the present invention. The circuit is formed by using polysilicon or amorphous silicon and comprises a shift register, as in the circuit shown in Fig. 14.

To the image signal lines 12 are input the signals obtained by cyclically rearranging R, G, B primary color signals with the horizontal period matched with the arrangement of the color filters of a color matrix panel in the horizontal direction thereof.

Fig. 19 shows the data sampling time chart of the the data sampling circuit shown in Fig. 18. In this embodiment, the sampling period is three times the time for a single pixel on a single line ($T_{(S/H)} = 3t_{(pitch)}$).

Like in Embodiment 1, the time constant of the LPF is set as follows.

$$\tau_{(LPF)} > T_{(S/H)} \ ( = 3t_{(pitch)})$$

This causes frequency components of $1/\tau_{(LPF)}$ or more to be cut off, and the image signal of $3t_{(pitch)}$ (corresponding to three pixels) to be integrated. Like in Embodiment 5, the sampling time satisfies the following condition:

$$T_{(S/H)} \ ( = 3t_{(pitch)}) = t_{(pitch)} > t_{(S/H)} > \tau_{(S/H)}$$

It is thus possible to faithfully reproduce each of the color signals of the color image signals.

(Embodiment 7)

Fig. 20 shows a data sampling circuit in accordance with an embodiment of the present invention. The circuit is formed by using polysilicon or amorphous silicon and comprises shift registers, as in the circuit shown in Fig. 14.

In this embodiment, a V/I conversion circuit 90 serving as an integration circuit is inserted into the image signal line 12 in order to realize the same effects as those obtained in Embodiment 4. The image signal is converted into a current signal by the V/I conversion circuit 90 and turns the sampling transistors on by the sampling pulses respectively output from portions 16, 17 and 18 so as to charge the hold capacity 44. An example of the V/I conversion circuit 90 is shown on the right side of the drawing. In the circuit 90, an input signal is clamped at the PRF voltage by CP, and is compared with the PEF voltage to output a current.

Fig. 21 shows the sampling waveform of this embodiment. Sampling is performed so that the equation (3) below is satisfied, as shown in Fig. 21.

$$T_{(S/H)} = t_{(S/H)} = t_{(pitch)} \quad (3)$$

If the image voltage signal is $v_{(t)}$, the hold voltage $V_{(H)}$ is the following:

$$V_{(H)} = 1/c \int_0^{t_{(S/H)}} i\,(V_{(t)})\,dt$$

(wherein c is the value of the hold capacity 44), and integration is thus made for the sampling time, i.e., a single pixel period. It is thus possible to faithfully reproduce an image, as in Embodiment 4, and faithfully reproduce a color image from color image signals, as in Embodiment 6.

(Embodiment 8)

In this embodiment, the data sampling circuit of each of Embodiment 4 to 7 is formed on a single crystal substrate.

When the data sampling circuit is applied to a display panel having at least 500 pixels in the horizontal direction thereof, since the blanking period of the one horizontal scanning period of 63.5 μsec is 10.8 μsec, the effective scanning period is 52.7 μsec. For example, when the number of pixels in the horizontal direction is 500, the following equation is obtained:

$$t_{(pitch)} = 52.7\ \mu sec/500 = 105\ nsec$$

In addition, when a sampling transistor is formed by using polysilicon or amorphous silicon, (ON resistance of the sampling transistor) + (wiring resistance) is 10 kΩ, and (hold capacity) + (wiring capacity) is about 30 pF. The sampling time constant $\tau_{(S/H)}$ is thus the following:

$$\tau_{(S/H)} = 10\ k\Omega \times 30\ pF = 300\ nsec$$

Since the condition in Embodiments 4 to 7, $t_{(pitch)} > t_{(S/H)} > \tau_{(s/H)}$, is not satisfied, the data sampling circuit cannot be applied to a display panel having many pixels.

When a sampling transistor is formed by using a single crystal, (ON resistance of the sampling transistor) + (wiring resistance) is 1 kΩ, and (hold capacity (comprising MOS capacity) + (wiring capacity) is about 10 pF. The sampling time constant $\tau_{(S/H)}$ is thus the following:

$$\tau_{(S/H)} = 1\ k\Omega \times 10\ pF = 10\ nsec$$

Since the condition, $t_{(pitch)} > t_{(S/H)} > \tau_{(S/H)}$, is sufficiently satisfied, the data sampling circuit can be satisfactorily applied to a display panel having at least 500 pixels in the horizontal direction thereof, as described above in Embodiments 1 to 3.

The single crystal semiconductor used for producing the sampling transistor is preferably formed by the method shown in Figs. 6(a) to 6(c). As a matter of course, the single crystal semiconductor may have the structure shown in Figs. 7(a) to 7(e).

(Embodiment 9)

Fig. 22 is a drawing showing a driving circuit of an active matrix liquid crystal display device in accordance with Embodiment 9 of the present invention, Fig. 23 is a drawing showing the configuration of the circuit in a portion surrounded by one-dot chain line 110 in Fig. 22, and Fig. 24 is a timing chart.

In Figs. 22 and 23, reference numeral 101 denotes a horizontal shift resistor; reference numeral 102, a sample and hold (S/H) circuit; reference numeral 103, a vertical shift register; reference numeral 104, an active matrix liquid crystal panel; reference numeral 105, a transfer MOS transistor; reference numerals 106 to 108, three-line video input; reference numeral 109, a transfer pulse; reference numeral 201, a sampling MOS transistor; and reference numeral 202, a buffer capacity.

To the three line of video input 106 to 108 are input the signals (image signals) obtained by cyclically rearranging the connection order of R, G, B primary color signals with the horizontal period matched with the arrangement of the color filters of a liquid color matrix panel 104 in the horizontal direction thereof.

The video signals are successively sampled by the horizontal shift resistor 101 and the sampling MOS transistor 201 with the one horizontal scanning period (1H period), and are held by the buffer capacity 202. The held charge is transmitted through the transfer MOS transistor 105 during the horizontal blanking period, as shown by the timing chart in Fig. 24, and is written in the pixels selected by the vertical shift register 103.

Since the above driving method permits the size of the sampling MOS transistor 201 to be increased, as compared with the TFT of each of the pixels, the value of the ON resistance can be decreased. The time constant determined by the buffer capacity 202 and the ON resistance is thus decreased, thereby satisfying the sampling time even when the number of pixels is increased.

In addition, since the time for transmitting signals to each of the pixels may be within the one horizontal blanking period, the speed of the driving circuit is increased to about 100 times that of a conventional method.

The circuit component portion shown in Fig. 23 is formed in a single crystal layer formed on a glass substrate. Fig. 25 is a sectional view showing the structure of the circuit component portion shown in Fig 23, and Fig. 6 explains the process of producing the single crystal layer.

As shown in Fig. 25, a sampling MOS transistor 201, a buffer capacity 202 and a transfer MOS transistor 105 are formed on a glass substrate 3, through an oxide layer 6 (insulating layer), and the respective semiconductor elements are insulated and separated from each other by selective insulating regions 4.

In this embodiment, the selective insulating regions 4 are formed at predetermined positions of the single crystal Si layer 2 on the light transmitting substrate 3 shown in Fig. 6(c) by LOSOS oxidation or the like to form element separating regions. The sampling MOS transistor 201, the buffer capacity 202 and the transfer MOS transistor 105 are respectively formed in the element separating regions 4 by usual MOS transistor production process, as shown in Fig. 25.

This permits the size of the circuit to be decreased without deteriorating the image quality, and an attempt to be made to decrease the cost.

(Embodiment 10)

Fig. 26 is a drawing showing a portion of the driving circuit of an active matrix liquid crystal display device in accordance with Embodiment 10 of the present invention. The portion shown in Fig. 26 corresponds to the portion surrounded by one-dot chain line 110 in Fig. 22. Fig. 27 is a timing chart.

In Fig. 26, reference numerals 106 to 108 denote three-line video input; and reference numeral 201 denotes a sampling MOS transistor. Reference numerals 401 and 402 each denote a first transfer gate; reference numerals 403 and 404, a second transfer gate; reference numerals 405 and 406, a buffer capacity; reference numerals 407 and 408, a first transfer gate pulse; and reference numerals 409 and 410, a second transfer gate pulse. The three-line video input is the same as that in Embodiment 9.

The operation of the driving circuit is described below with reference to the timing chart shown in Fig. 27.

Since on line n, pulse $\varnothing_{S1}$ 407 is high (H), and pulse $\varnothing_{T1}$ 409 is low (L), when the sampling transistor MOS transistor 201 to the gate of which a signal is sent from the horizontal shift register is turned on, the signals of the video lines are held by the first buffer 405.

Since on line n + 1, pulse $\varnothing_{S1}$ 407 is L, and pulse $\varnothing_{T1}$ 409 is H, the charge held by the first buffer capacity is written in each of the pixels. At the same time, since pulse $\varnothing_{S2}$ 408 is H, and pulse $\varnothing_{T2}$ 410 is L, when the sampling MOS transistor 201 to the gate of which a signal is set from the horizontal shift register is turned on, the signals of the video lines are held by the second buffer capacity.

The above operation is repeated so that the video signals of each line are sampled and held and transmitted to each of the pixels by alternately using the different buffer capacities.

In the above driving method, the time for transferring signals to each of the pixels may be one horizontal scanning period.

Even in a high vision (HD) having a horizontal blanking period of as short as 3 μsec, the time for transferring signals to each of the pixels may be within the horizontal scanning time of 30 μsec, thereby increasing the speed by 10 times.

The circuit component portion shown in Fig. 26 is formed on the single crystal Si layer on the glass substrate produced in the process shown in Fig. 6, as in Embodiment 9 shown in Fig. 25.

(Embodiment 11)

Fig. 28 is a drawing showing a portion of the driving circuit of the active matrix liquid crystal display device in accordance with Embodiment 3, the portion corresponding to the portion surrounded by one-dot chain line 110 in Fig. 22. In this embodiment, signals are written in adjacent pixels in the vertical or horizontal direction with opposite polarities in order to inhibit the occurrence of flicker over the whole panel of the active matrix liquid crystal display device. Fig. 29 is a timing chart when signals are written with opposite polarities in the vertical direction, and Fig. 30 is a timing chart when signals are written with opposite polarities in the horizontal direction.

In Fig. 28, reference numerals 605 to 607 and 608 denote three-line video input and reverse signals; reference numerals 611 and 612 respectively denote normal/reverse selection pulses; reference numeral 109 denotes a transfer pulse; reference numerals 601 and 602 each denote a sampling MOS transistor; reference numerals 603 and 604 respective denote normal and reverse transfer gates; reference numeral 202 denotes a buffer capacity; and reference numeral 105 denotes a transfer MOS transistor.

A description is made of the operation when signals are written in adjacent pixels in the vertical direction with opposite polarities in accordance with the timing charge shown in Fig. 29. Since, on line n, pulse $\varnothing_{inv}$ is L, and inverted pulse $\varnothing_{inv}$' is H, when a signal is set to the gates of the sampling MOS transistors 601 and 602 from the horizontal shift register, and when the sampling MOS transistors 601 and 602 are turned on, the normal video signals are sampled and held by the buffer capacity 202. The signals are written in each of the pixels during the next blanking period in which the transfer MOS transistor 105 is turned on. Since, on line n + 1, pulse $\varnothing_{inv}$ is H, and pulse $\varnothing_{inv}$' is L, the inverted video signals are sampled and held by the buffer capacity 202. The signals are written in each of the pixels during the next blanking period.

In addition, since the signals of pulse $\varnothing_{inv}$ and pulse $\varnothing_{inv}$' are inverted with the vertical scanning period (one frame), alternating current driving is performed in any one of the pixels.

Further, since the phase of the waveform of writing on a line is shifted from that on the adjacent line by one field, when the waveforms are combined, an optical flicker component is shifted by 1/2 period, and the basic waveform has one field period. The effective frequency is thus doubled, thereby significantly restricting the occurrence of flicker.

A description is made of the operation when signals are written in adjacent pixels in the horizontal direction with opposite polarities in accordance with the timing charge shown in Fig. 29. Since pulse $\varnothing_{inv}$ and pulse $\varnothing_{inv}$' are synchronized with the lock of the horizontal shift register, video signals having opposite polarities are sampled and held by the adjacent buffer capacities 202. The signals are written in each of the pixels during the next horizontal blanking period.

In addition, since the signals of pulse $\varnothing_{inv}$ and pulse $\varnothing_{inv}$' are inverted with the vertical scanning period (one frame), alternating current driving is performed in any one of the pixels. This effect is the same as in the case of the vertical direction.

The circuit component portion of this embodiment shown in Fig. 28 is formed in the single crystal Si layer on the glass substrate produced by the process shown in Fig. 6, like in Embodiment 1 shown in Fig. 25.

As described above, in the driving method according to the present invention, the LPF having a time constant longer than the sampling time or the integration means is inserted into the image signal line so that the high-frequency components of the input image signals are cut off, thereby inhibiting moire from occurring in the image signals due to components having frequencies higher than the sampling frequency, and reproducing a more faithful image. In addition, since the sampling transistor of the sampling circuit is formed by using a single crystal semiconductor, the sampling time constant can be decreased, and the driving circuit can be speeded up. The present invention can thus be applied to a high-fineness image having many pixels and a large image plane and thus permits the display of a clear image.

The present invention also permits high-speed driving and high-speed driving with high image quality and high fineness and permits a decrease in the chip size and an attempt to be made to decrease the cost.

## Claims

1. A method of producing an image display device comprising a semiconductor circuit having a sampling circuit for successively sampling analog image signals for each data line of a matrix, and a circuit for supplying image signals to each of pixels on the basis of the sampled data, and display means for displaying an image on the basis of said image signals; said method comprising:
   the step of forming a single crystal Si layer in which said semiconductor circuit is formed by a method including the steps of forming single crystal Si on a porous Si substrate, bonding said single crystal Si to a light transmitting substrate or a Si substrate through an insulating layer, and removing said porous Si substrate; and
   the step of forming at least a portion of elements which constitute said semiconductor circuit by employing the single crystal Si layer formed.

2. A method according to Claim 1, wherein said single crystal Si is formed by at least one method selected from the group consisting of a molecular beam epitaxial growth method, a plasma CVD method, a thermal CVD method, an optical CVD method, a bias sputtering method, and a liquid crystal growth method.

3. A method according to Claim 1, wherein said porous Si substrate is removed by etching.

4. A method according to Claim 3, wherein said etching is wet etching.

5. A method according to Claim 4, wherein said wet etching is effected by using an etching solution containing hydrofluoric acid or buffered hydrofluoric acid.

6. A method according to Claim 5, wherein said etching solution further contains att least one solution selected from the group consisting of ammonium fluoride, hydrofluoric acid, an aqueous hydrogen peroxide solution and alcohols.

7. A method according to Claim 4, wherein said wet etching is effected by using a solution containing sodium hydroxide.

8. A method according to Claim 1, wherein said light transmitting substrate is a glass substrate.

9. A method according to Claim 1, wherein said insulating layer is an oxide layer.

10. A method according to Claim 1, further comprising the step of forming at least an anti-etching film on the sides of said single crystal Si before the step of removing said porous Si substrate.

11. A method according to Claim 5, wherein the HF concentration of the buffered hydrofluoric acid is 1 to 95 % by weight relative to the weight of the etching solution used.

12. A method according to Claim 5, wherein the concentration of ammonium fluoride in said buffered hydrofluoric acid is 1 to 95 % by weight relative to the weight of the etching solution used.

13. A method according to Claim 5, wherein the concentration of hydrofluoric acid is 1 to 95 % by weight relative to the weight of the etching solution used.

14. A method according to Claim 6, wherein the concentration of hydrogen peroxide is 1 to 95 % by weight relative to the weight of the etching solution used.

15. A method according to Claim 6, wherein the concentration of an alcohol is 80 % by weight or less relative to the weight of the etching solution used.

16. A method according to Claim 4, wherein said wet etching is effected at 0 to 100°C.

17. A method according to Claim 6, wherein an alcohol is selected from ethyl alcohol and isopropyl alcohol.

18. A method according to Claim 1, wherein said semiconductor circuit has a low pass filter.

19. A method according to Claim 1, wherein said semiconductor circuit has integration means.

20. A method according to Claim 1, wherein said sampling circuit has switch means and a buffer capacity.

21. A method according to Claim 1, wherein said display means is liquid crystal display means.

22. A matrix type image display device comprising a sampling circuit for successively sampling analog image signals for each data line of a matrix and then distributing the sampled data to corresponding pixels, wherein the sampling transistor in said sampling circuit is formed from a single crystal.

**23.** A device according to Claim 22, wherein said analog image signals are time serial signals.

**24.** An image display device comprising sample and hold means for sampling and holding primary color signals cyclically rearranged with a horizontal scanning period in synchronism with a horizontal shift register so that the held signals are transferred to each of the pixels on the line selected by a vertical shift register:

wherein said sample and hold means has switch means using as a control signal the signal output from said horizontal shift register and a buffer capacity, at least said switch means and said buffer capacity being provided in the single crystal silicon layer formed on the surface of a light-transmitting substrate.

**25.** An image display device according to Claim 24, wherein said sample and hold means and transfer switch means for transferring the signals held to each of the pixels on the line selected by said vertical shift register are provided on the single crystal silicon layer formed on a surface of a light transmitting substrate.

**26.** An image display device according to Claim 25. wherein said sample and hold means and said transfer switch means are provided in two systems which are used alternately in horizontal scanning period.

**27.** An image display device according to Claim 24, further comprising a liquid crystal for performing display in the pixels.

**28.** An image display device comprising sample and hold means for alternately sampling and holding primary color signals and the inverted signals thereof which are cyclically rearranged with a horizontal scanning period with the horizontal scanning period or the pixel period in synchronism with a horizontal shift register so that the held signals are transferred to each of the pixels on the line selected by a vertical shift register:

wherein said sample and hold means has switch means using as a control signal the signal output from said horizontal shift register and a buffer capacity, at least said witch means and said buffer capacity being provide in the single crystal silicon layer formed on the surface of a light-transmitting substrate.

**29.** An image display device according to Claim 28, wherein said sample and hold means and transfer switch means for transferring the signals held to each of the pixels on the line selected by said vertical shift register are provided on the single crystal silicon layer formed on a surface of a light transmitting substrate.

**30.** An image display device according to Claim 28 further comprising a liquid crystal for performing display in the pixels.

**31.** A method of driving an image display device for displaying an image by successively sampling analog image signals for each data line of a matrix and then distributing the sampled data to the pixels, said method comprising inserting a low pass filter having a time constant greater than the sampling time into the image signal line.

**32.** A driving method according to Claim 31, wherein said analog image signals are time serial signals.

**33.** A method of driving an image display device for displaying an image by successively sampling analog image signals for each data line of a matrix and then distributing the sampled data to the pixels, said method comprising inserting integration means into the image signal line.

**34.** A driving method according to Claim 33, wherein said analog image signals are time serial signals.

**35.** A method according to Claim 1, further comprising forming selective insulating regions in predetermined regions of said single crystal semiconductor layer to form a plurality of element regions insulated and separated, and providing at least a portion of a circuit selected from said sampling circuit and a circuit for supplying image signals in each of said plurality of element regions.

FIG. 1
PRIOR ART

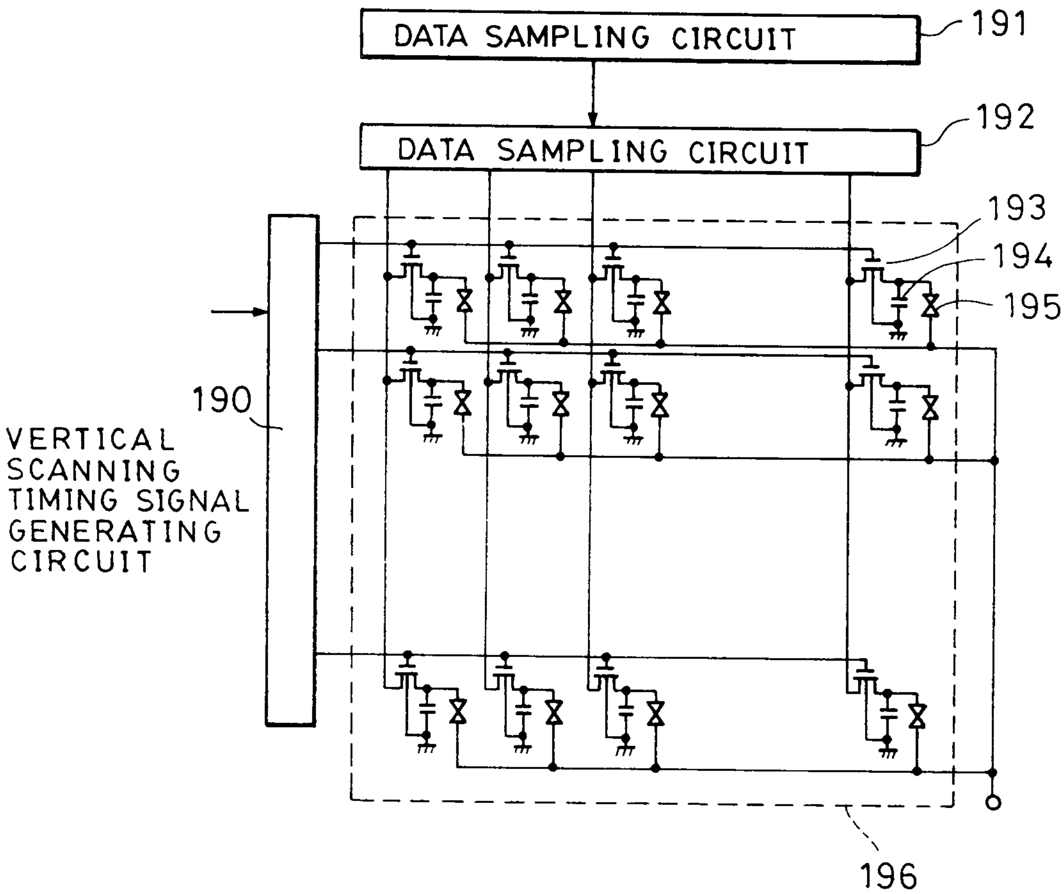

FIG. 2
PRIOR ART

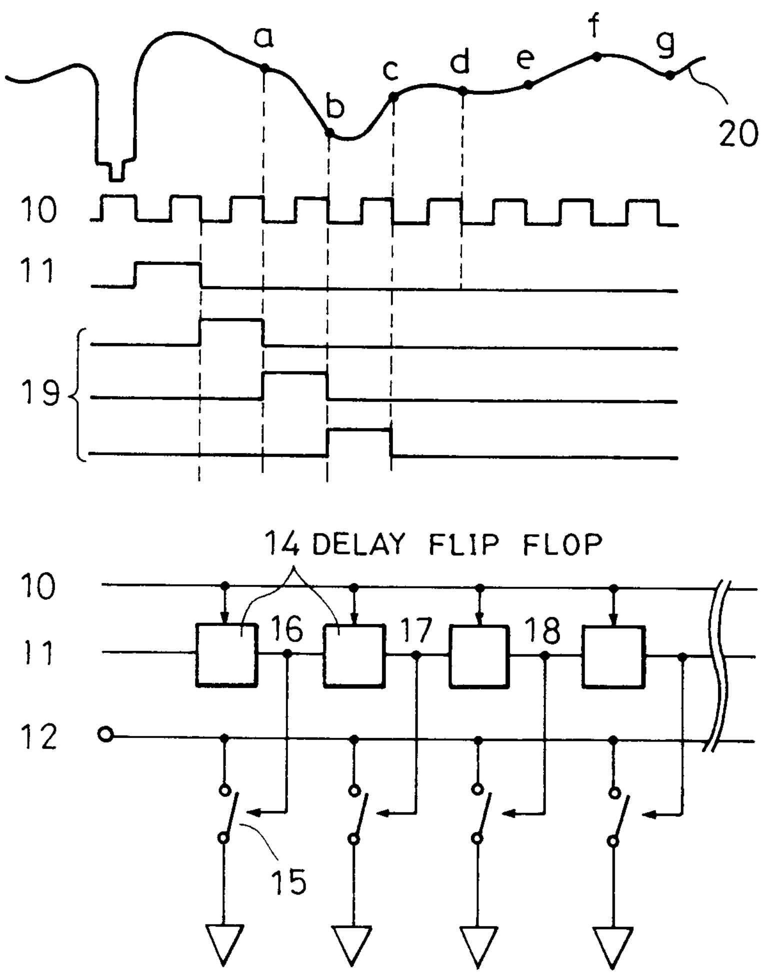

FIG. 3
PRIOR ART

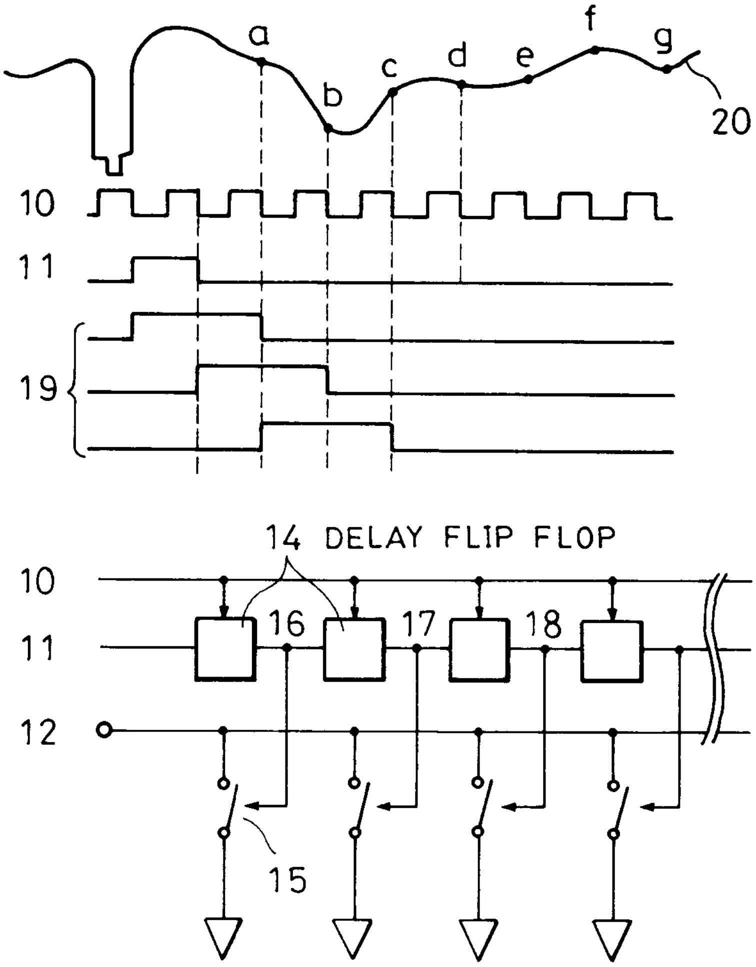

FIG. 4
PRIOR ART

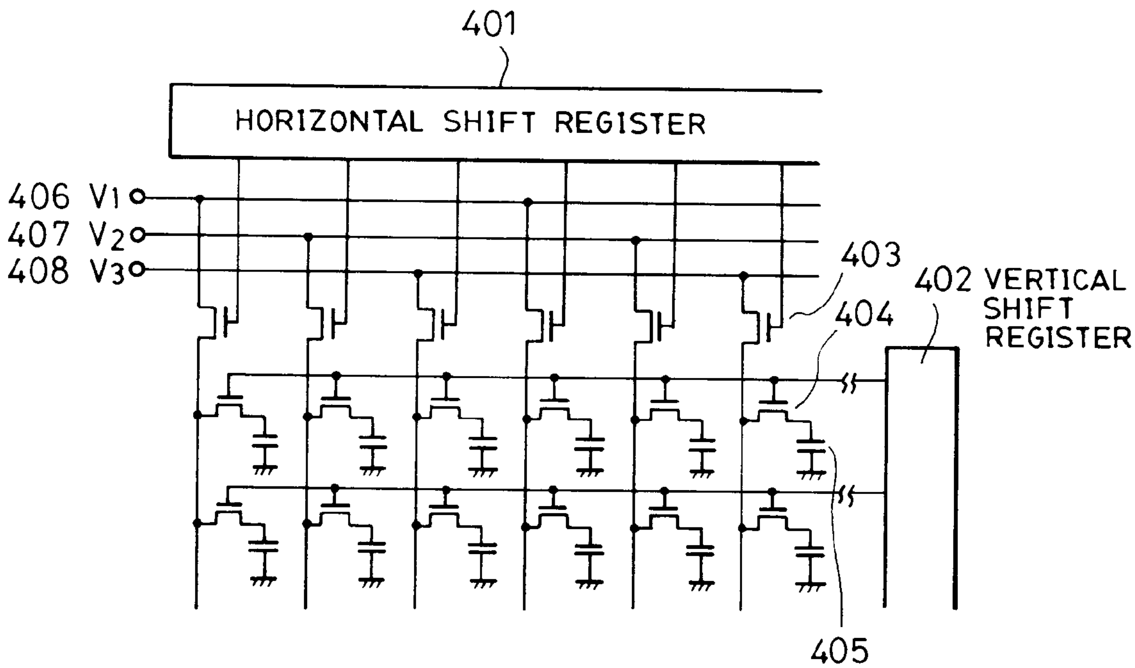

FIG. 5

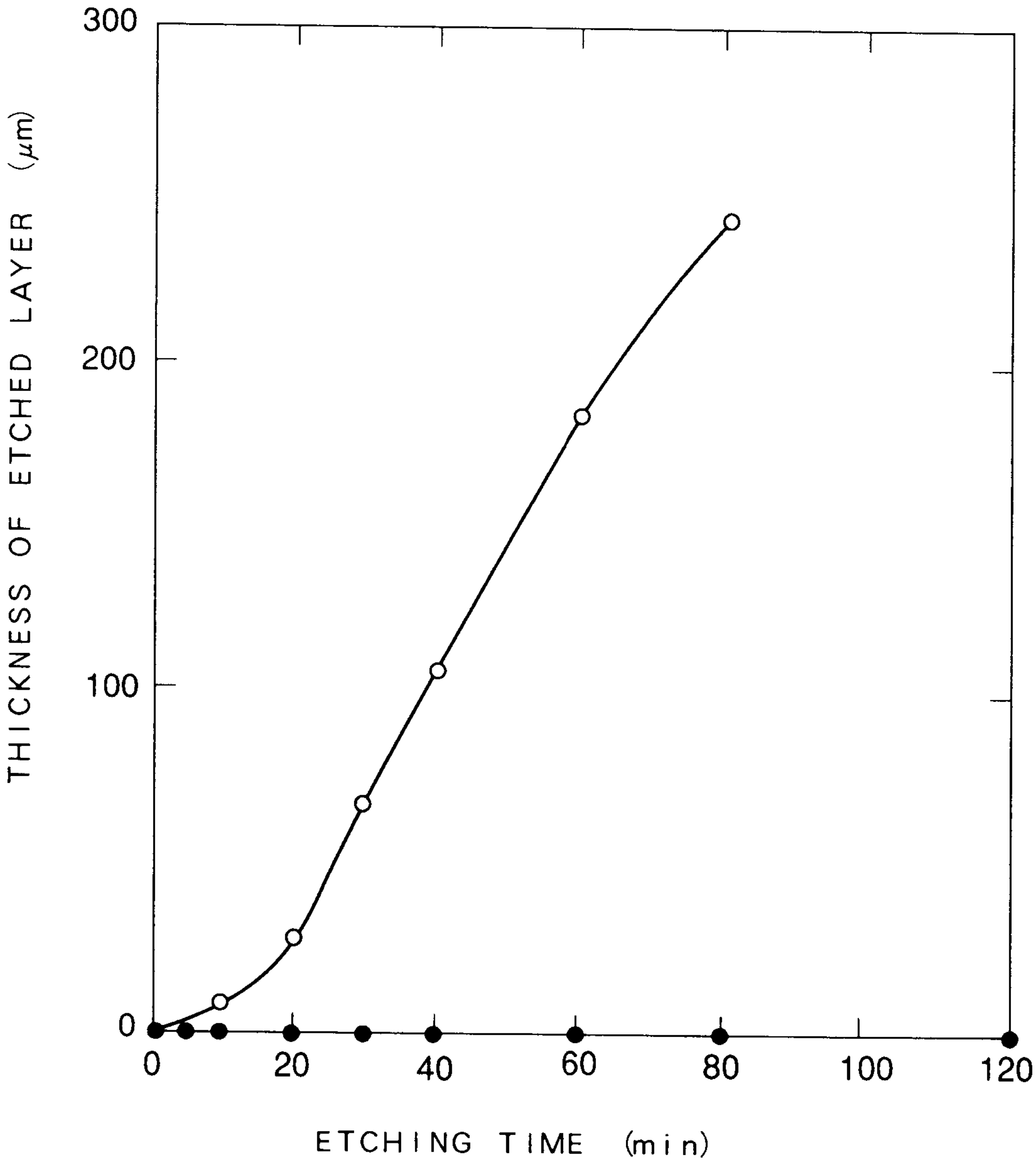
300
200
100
0
THICKNESS OF ETCHED LAYER (μm)
0
20
40
60
80
100
120
ETCHING TIME (min)

FIG. 6(a)

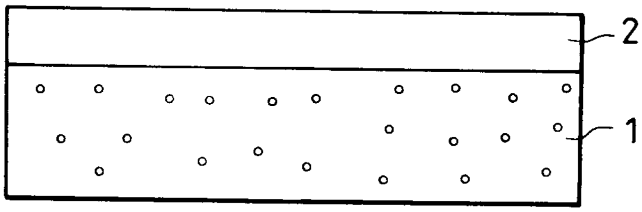


FIG. 6(b)

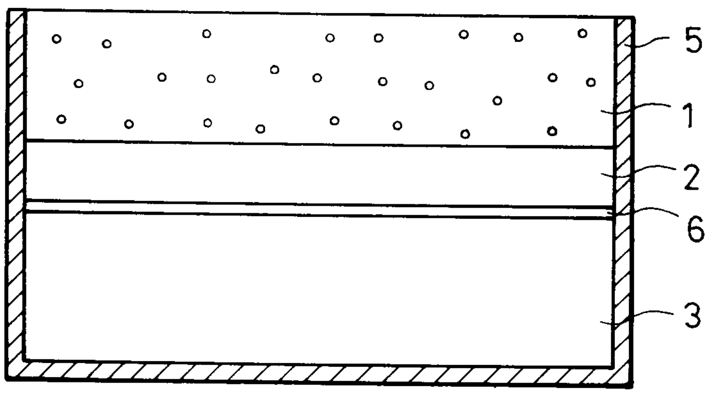


FIG. 6(c)

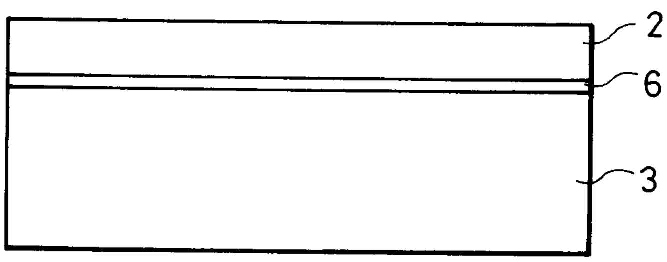

FIG. 7(a)

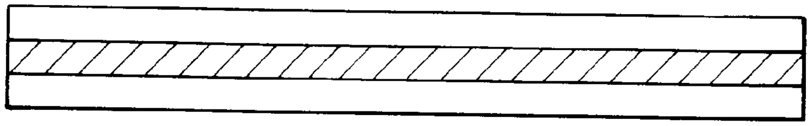

FIG. 7(b)

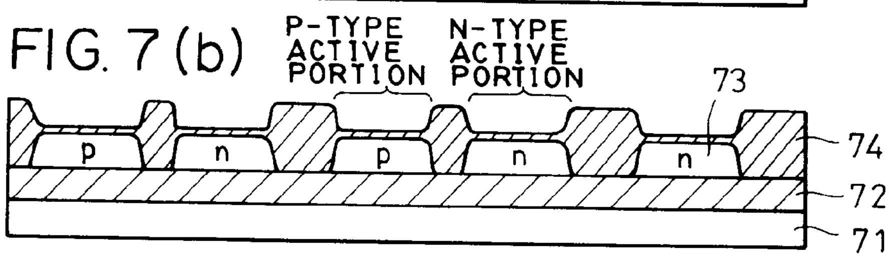


FIG. 7(c)

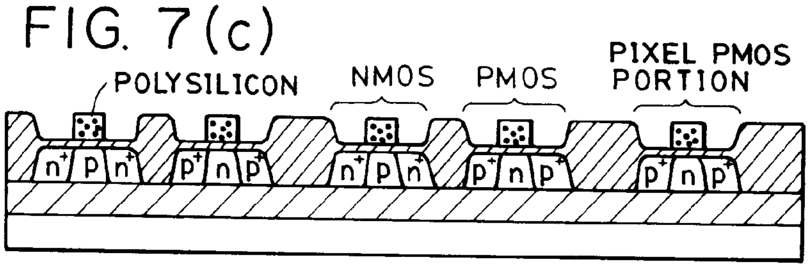


FIG. 7(d)

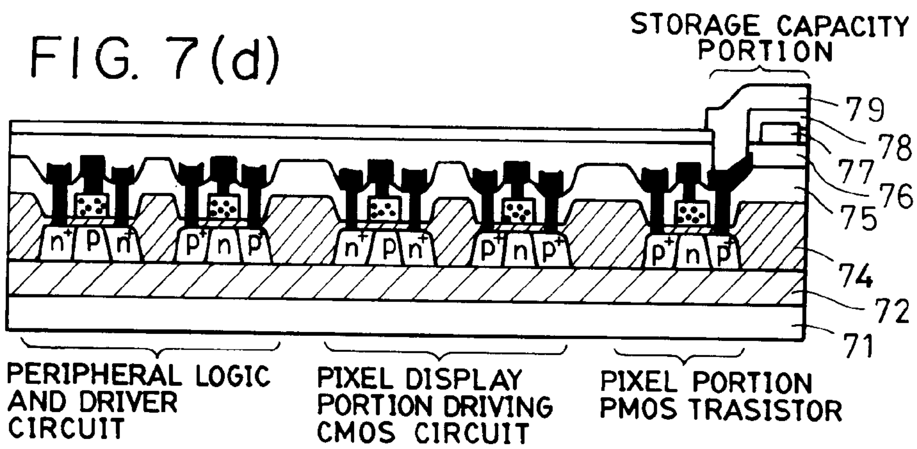


FIG. 7(e)

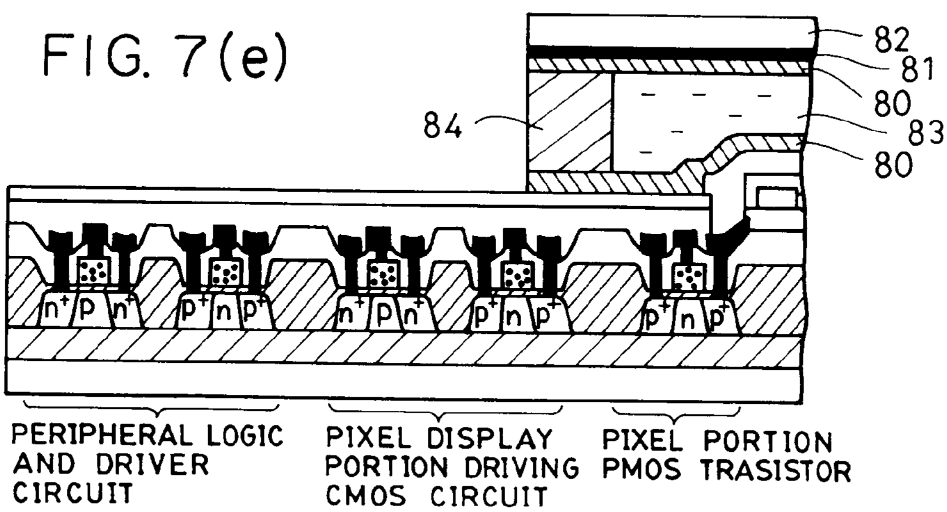

FIG. 7(f)

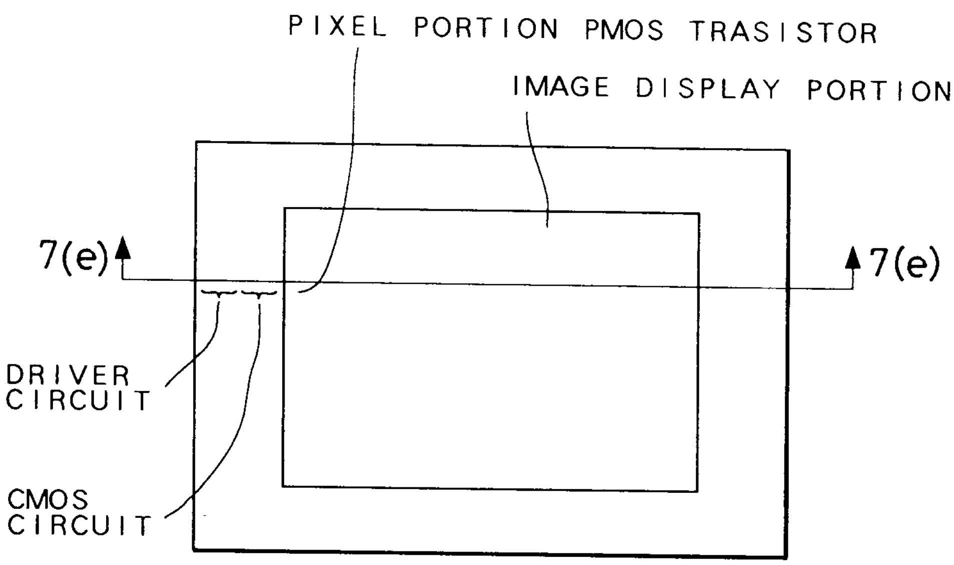
PIXEL PORTION PMOS TRASISTOR
IMAGE DISPLAY PORTION
7(e)
7(e)
DRIVER CIRCUIT
CMOS CIRCUIT

FIG. 8

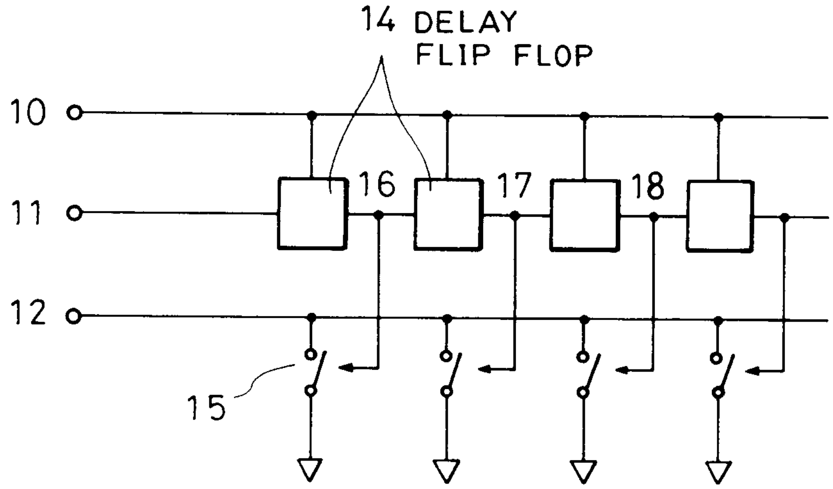
14 DELAY
FLIP FLOP
10
11
12
15
16
17
18

FIG. 9

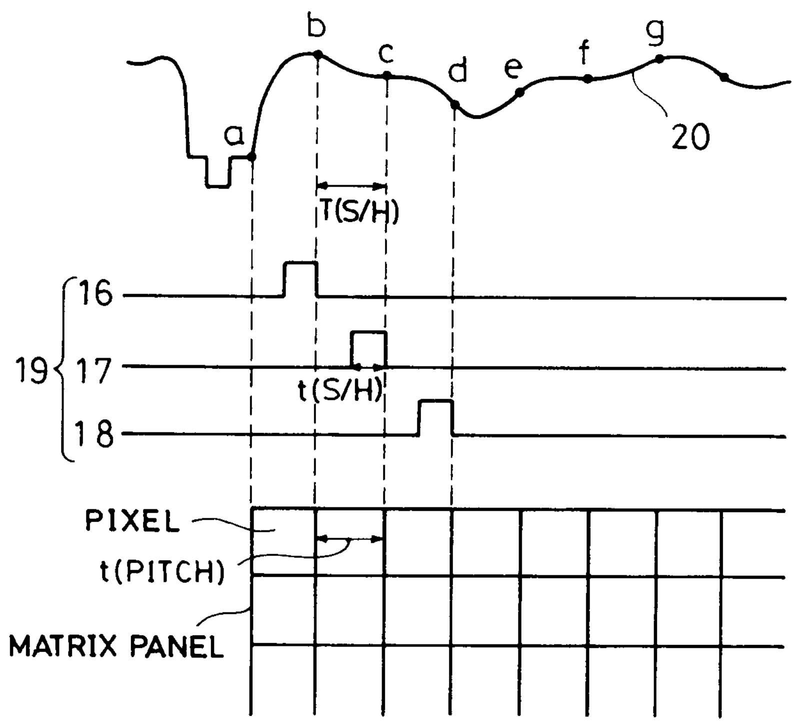
a
b
c
d
e
f
g
20
T(S/H)
16
19
17
18
t(S/H)
PIXEL
t(PITCH)
MATRIX PANEL

FIG. 10(a)

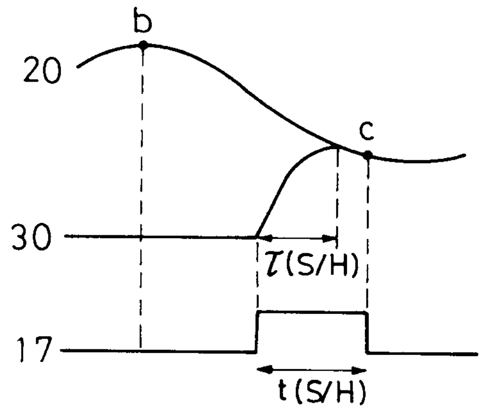


FIG. 10(b)

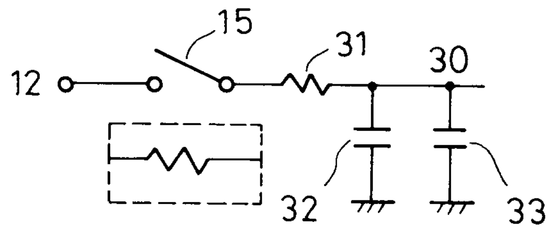


FIG. 11

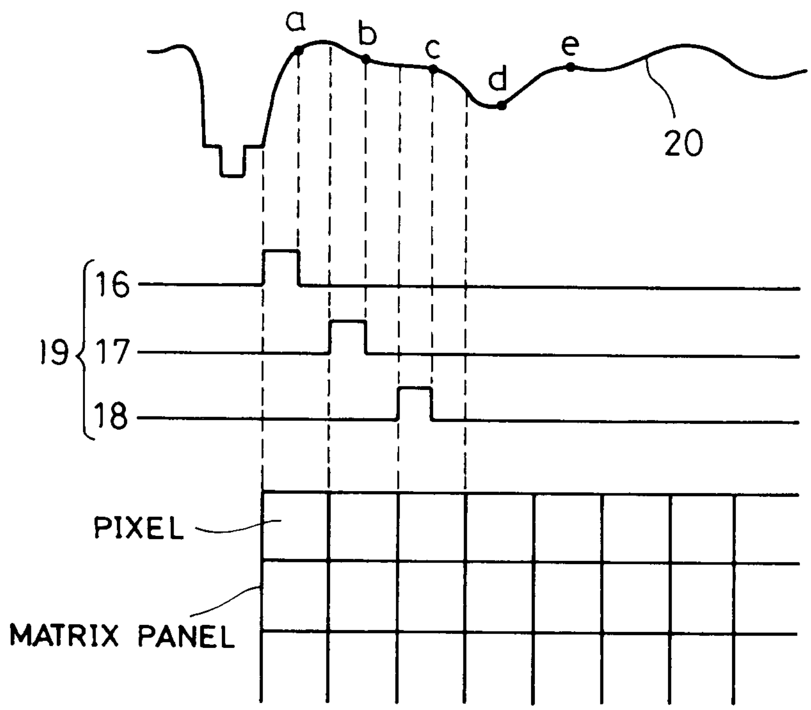

FIG. 12

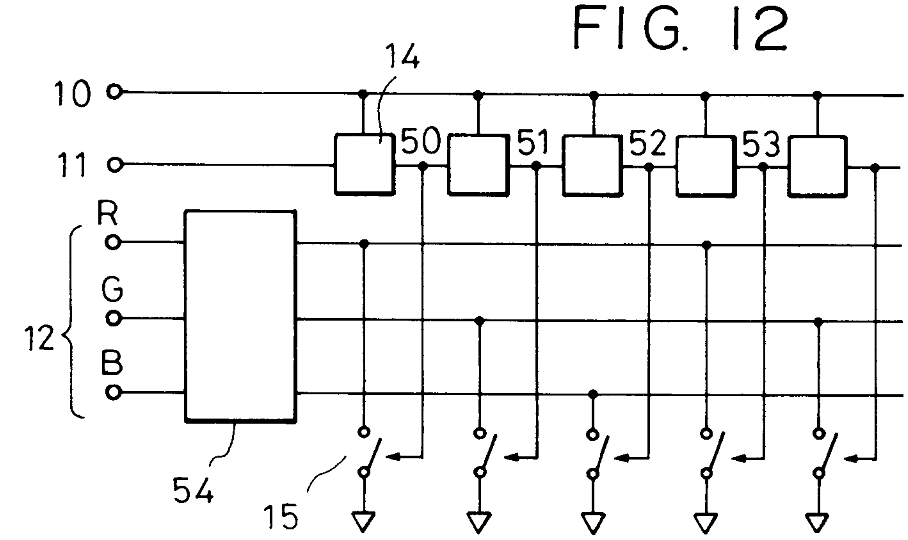
14
10
11
50
51
52
53
R
G
B
12
54
15

FIG. 13

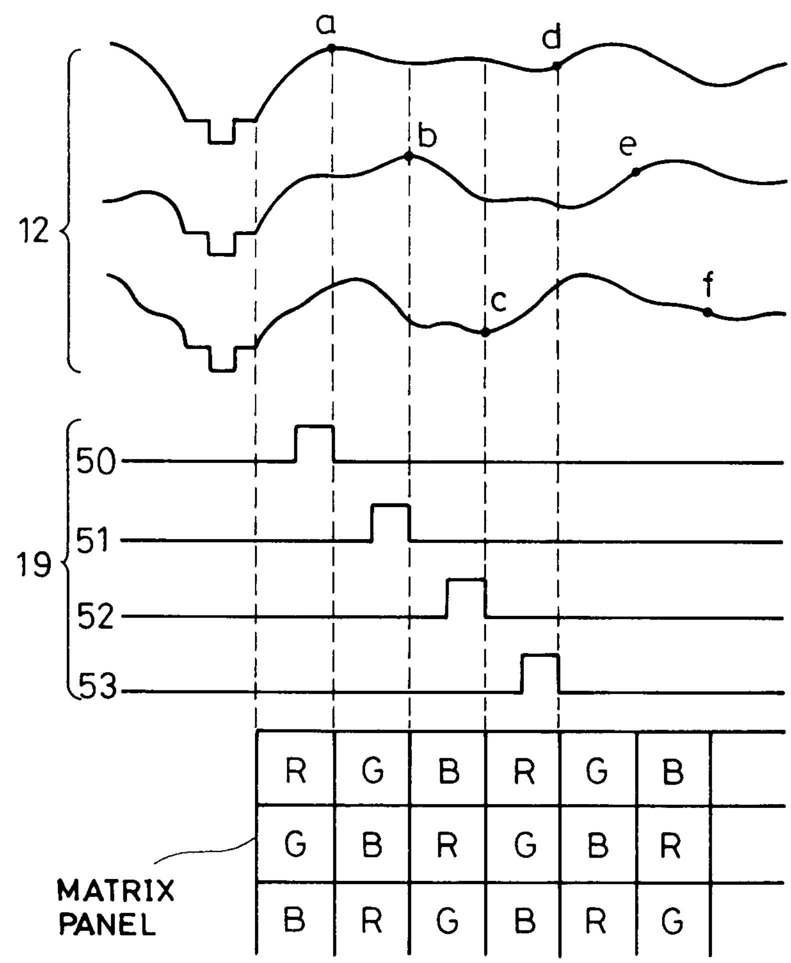
a
d
b
e
12
c
f
50
51
19
52
53
R G B R G B
G B R G B R
B R G B R G
MATRIX
PANEL

FIG. 14

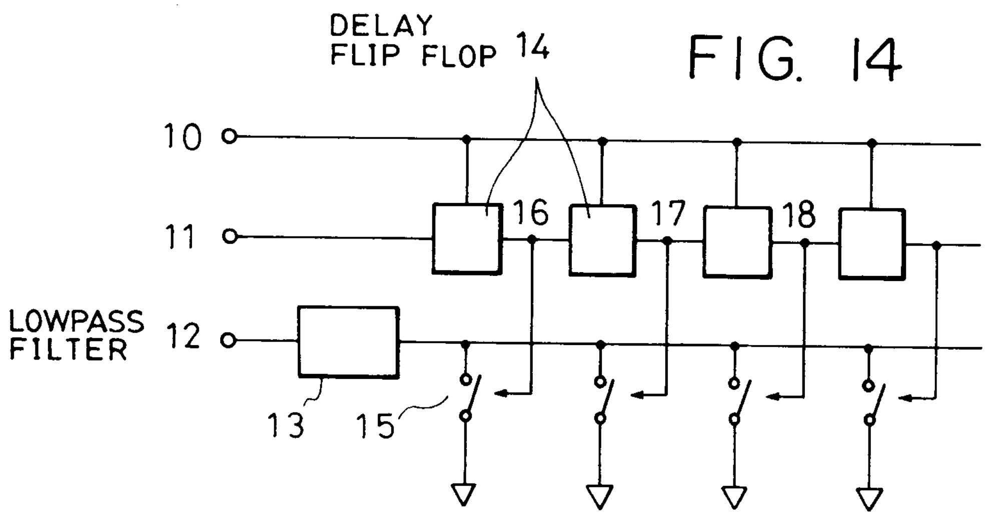
DELAY
FLIP FLOP 14
10
11
12
LOWPASS
FILTER
13
15
16
17
18

FIG. 15

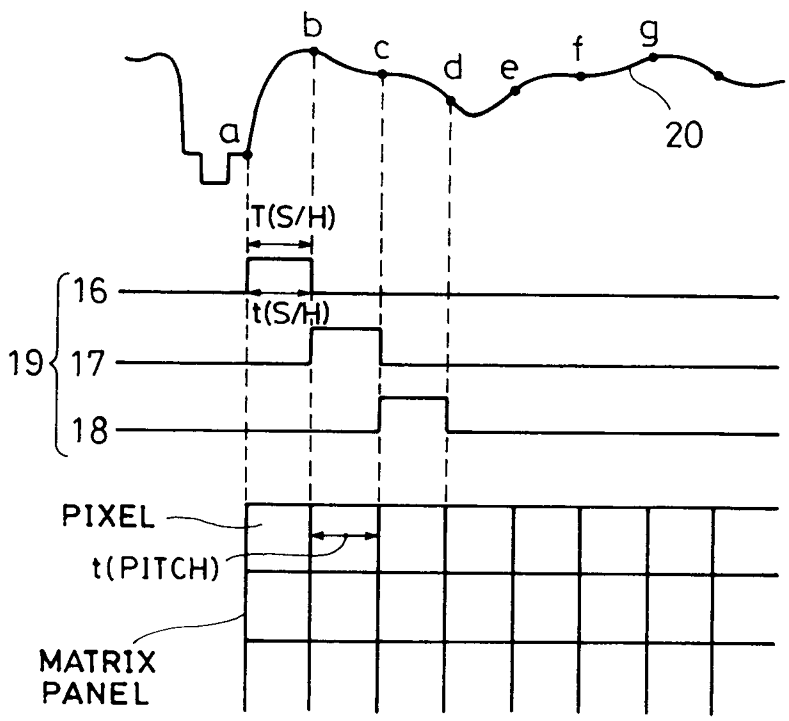
a
b
c
d
e
f
g
20
T(S/H)
t(S/H)
16
17
18
19
PIXEL
t(PITCH)
MATRIX
PANEL

FIG. 16

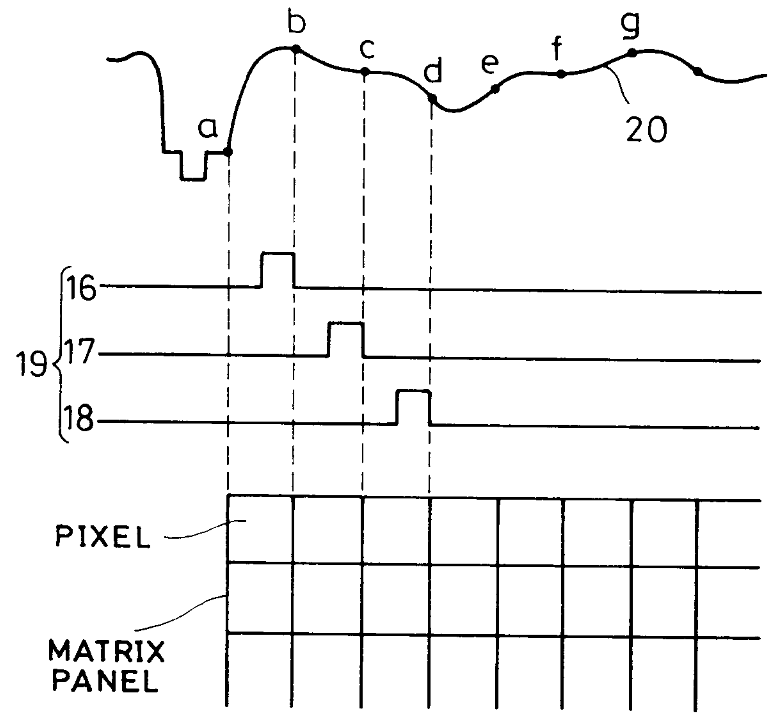
a
b
c
d
e
f
g
20
16
17
18
19
PIXEL
MATRIX
PANEL

FIG. 17

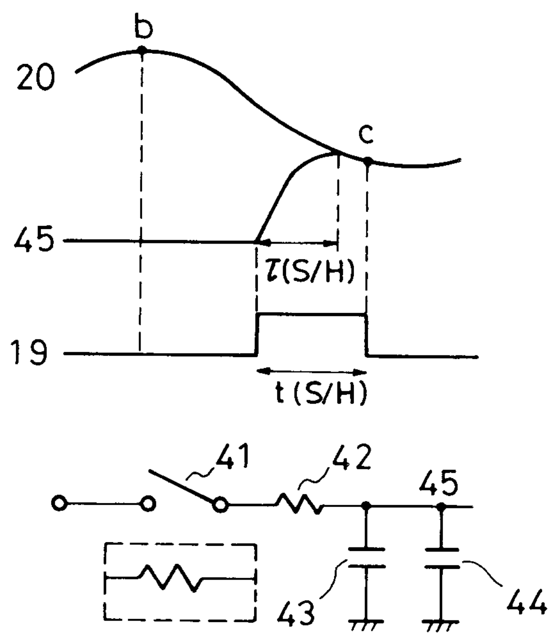
b
20
c
45
τ(S/H)
19
t (S/H)
41
42
45
43
44

FIG. 18

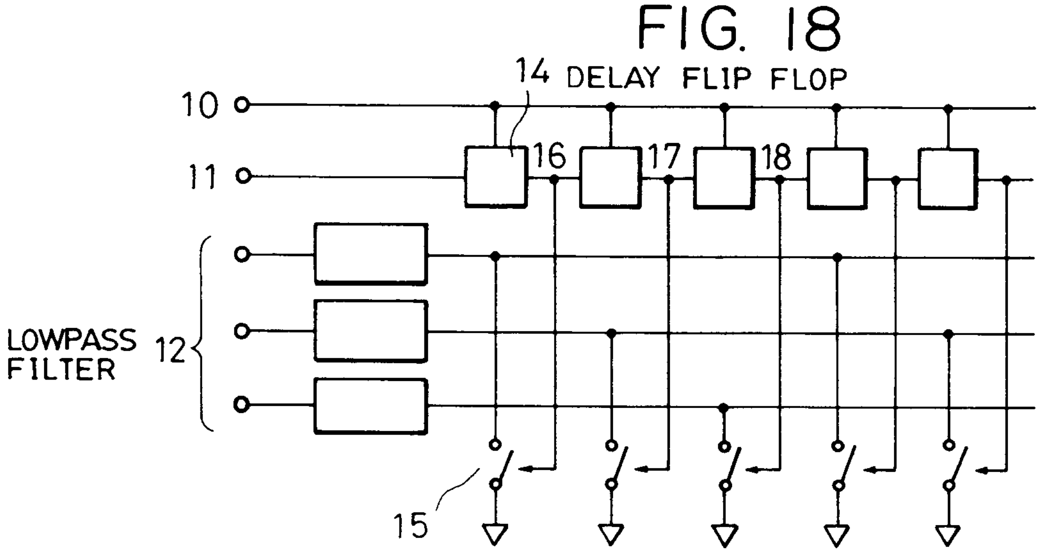
14 DELAY FLIP FLOP
10
11
16
17
18
LOWPASS FILTER
12
15

FIG. 19

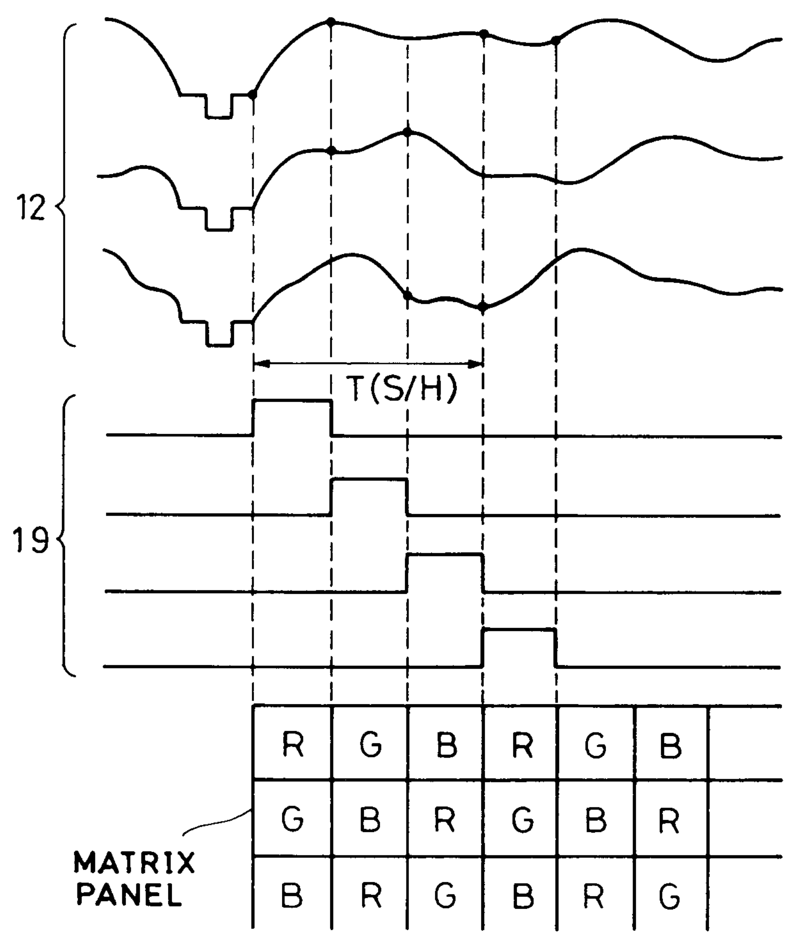
12
T(S/H)
19
R G B R G B
G B R G B R
B R G B R G
MATRIX PANEL

FIG. 20

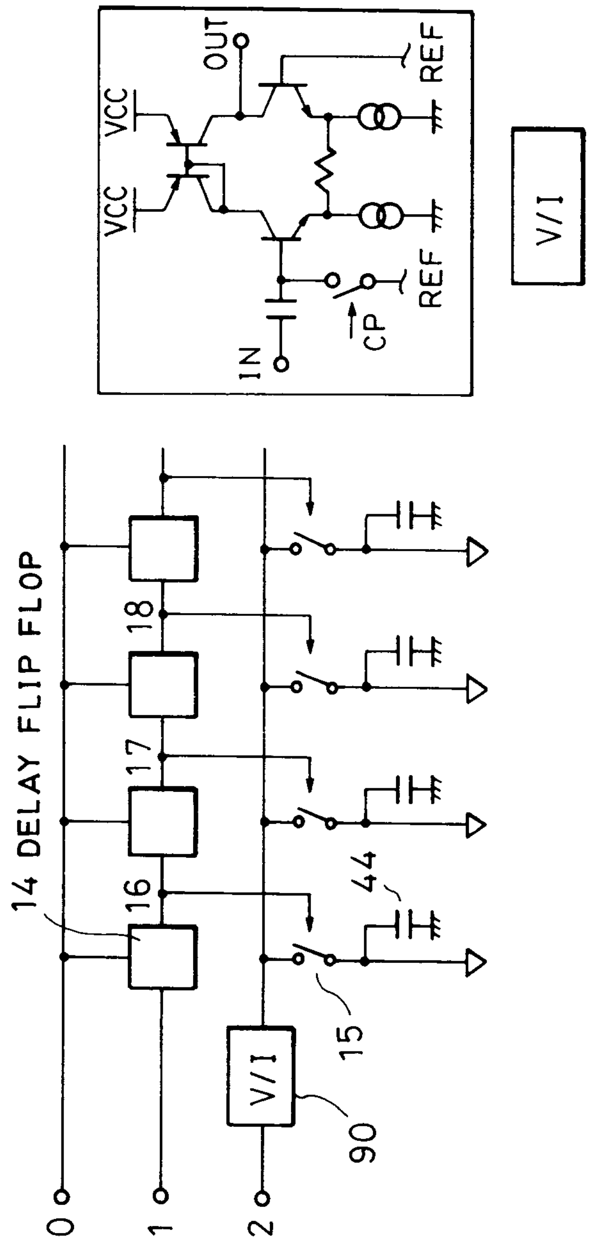
10
11
12
V/I
90
15
44
14 DELAY FLIP FLOP
16
17
18
VCC
VCC
OUT
IN
CP
REF
REF
V/I

FIG. 21

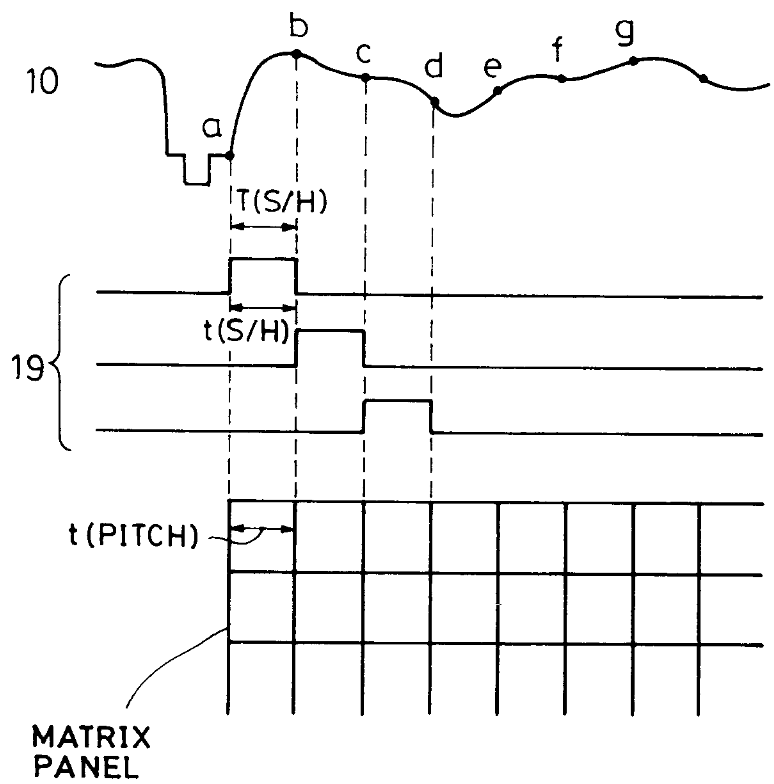

FIG. 22

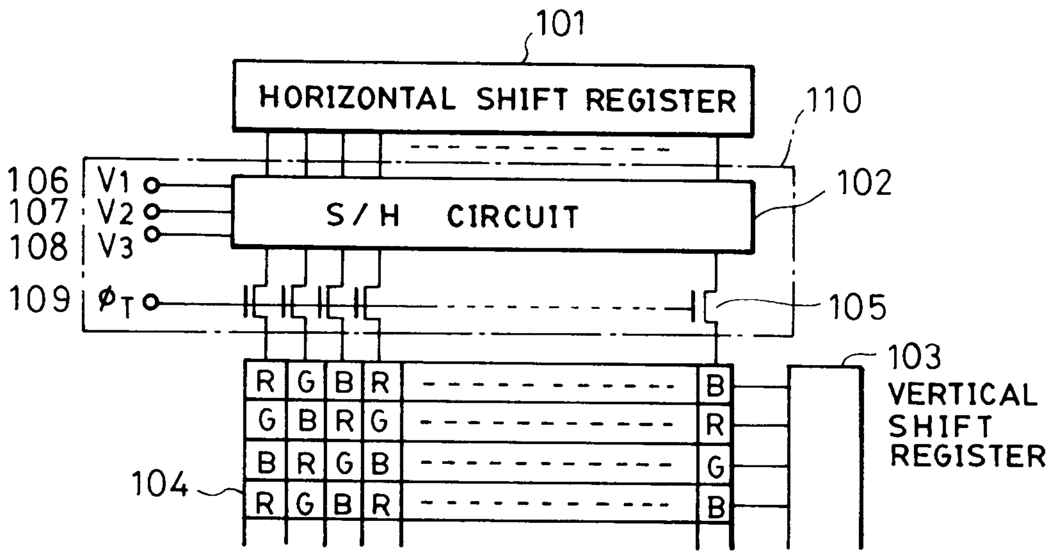
101
HORIZONTAL SHIFT REGISTER
110
106 V1
107 V2
108 V3
S/H CIRCUIT
102
109 φT
105
R G B R B
G B R G R
B R G B G
R G B R B
104
103
VERTICAL SHIFT REGISTER

FIG. 23

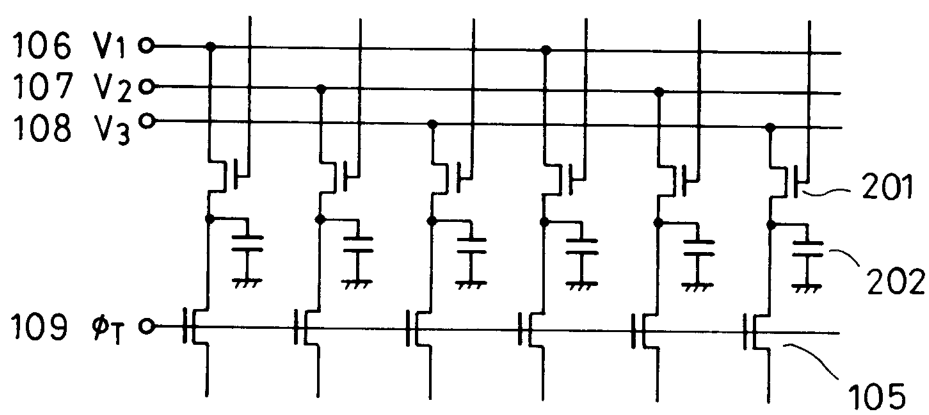
106 V1
107 V2
108 V3
201
202
109 φT
105

FIG. 24

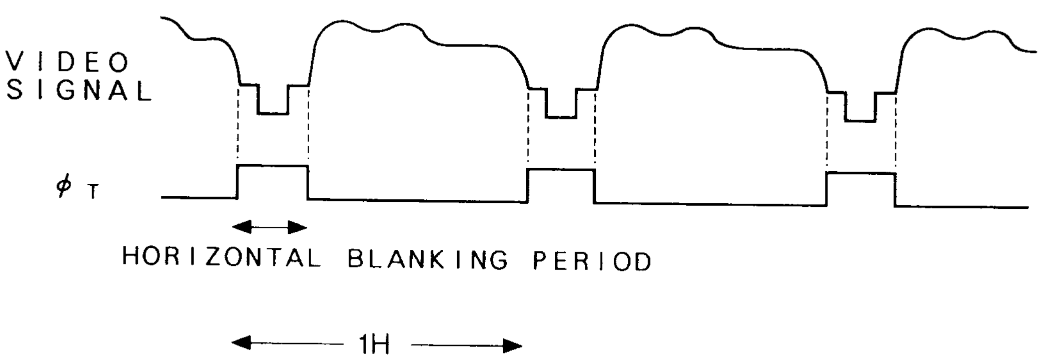

FIG. 25

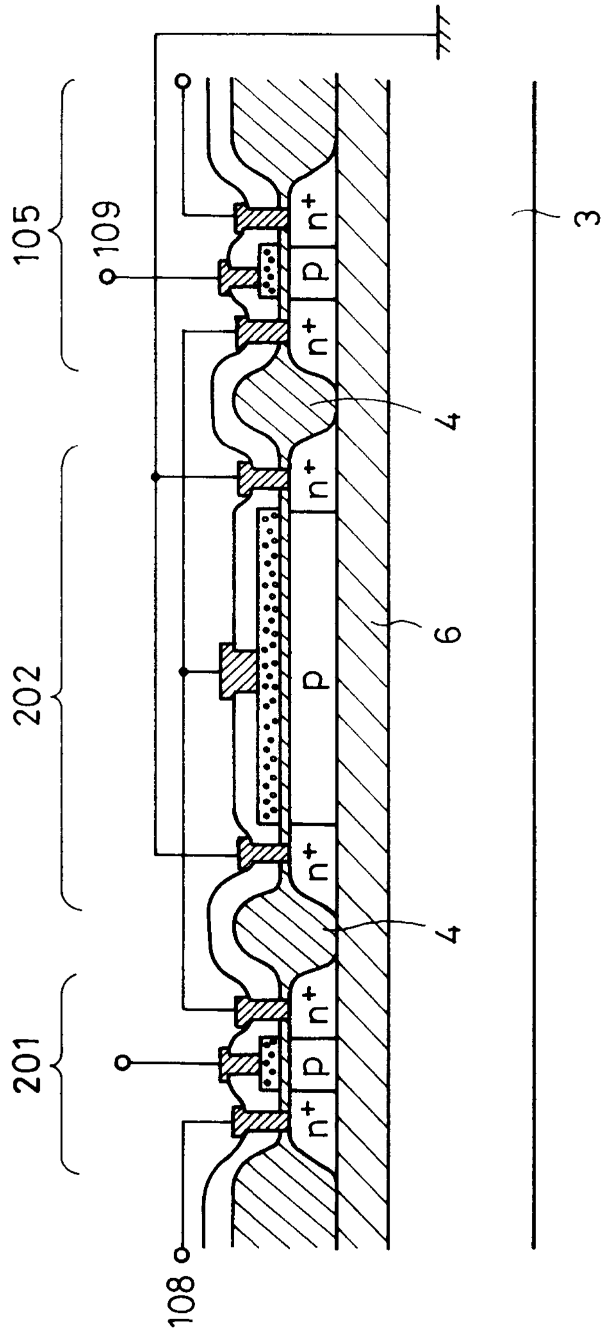

FIG. 26

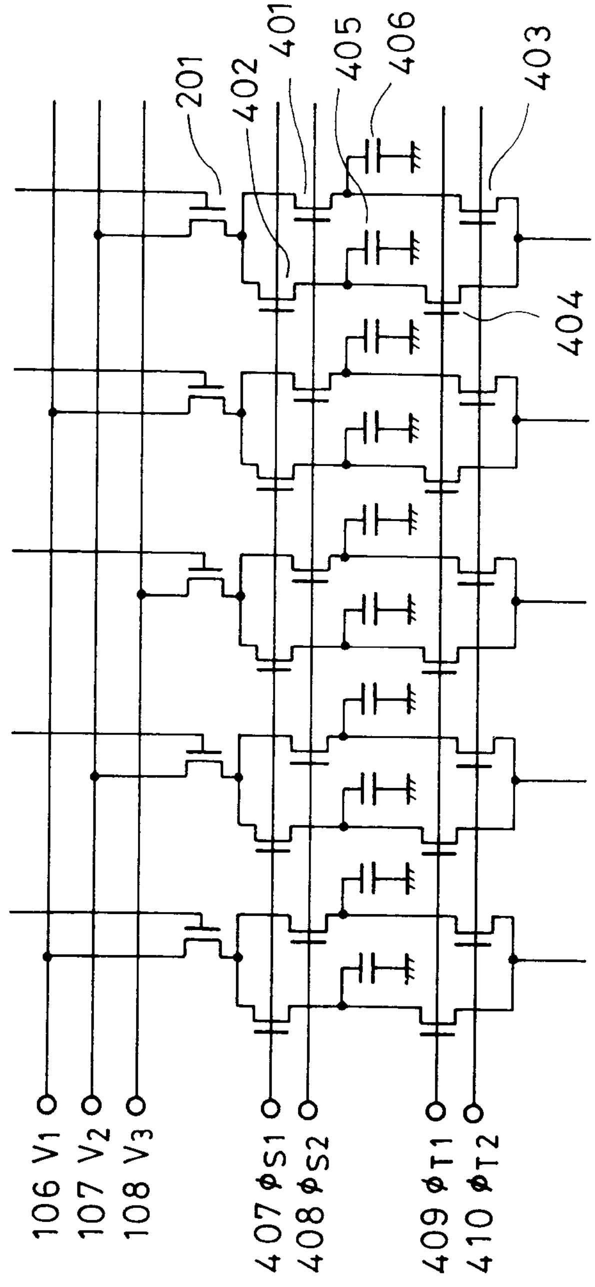

201
402
401
405
406
403
404
106 $V_1$
107 $V_2$
108 $V_3$
407 $\phi_{S1}$
408 $\phi_{S2}$
409 $\phi_{T1}$
410 $\phi_{T2}$

FIG. 27

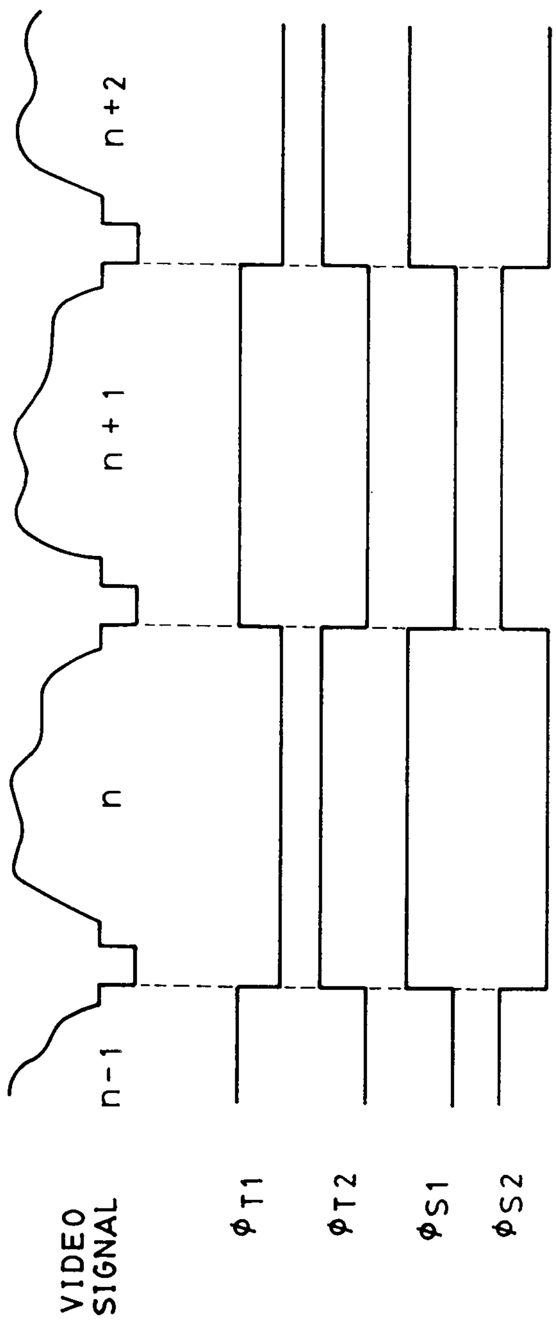

FIG. 28

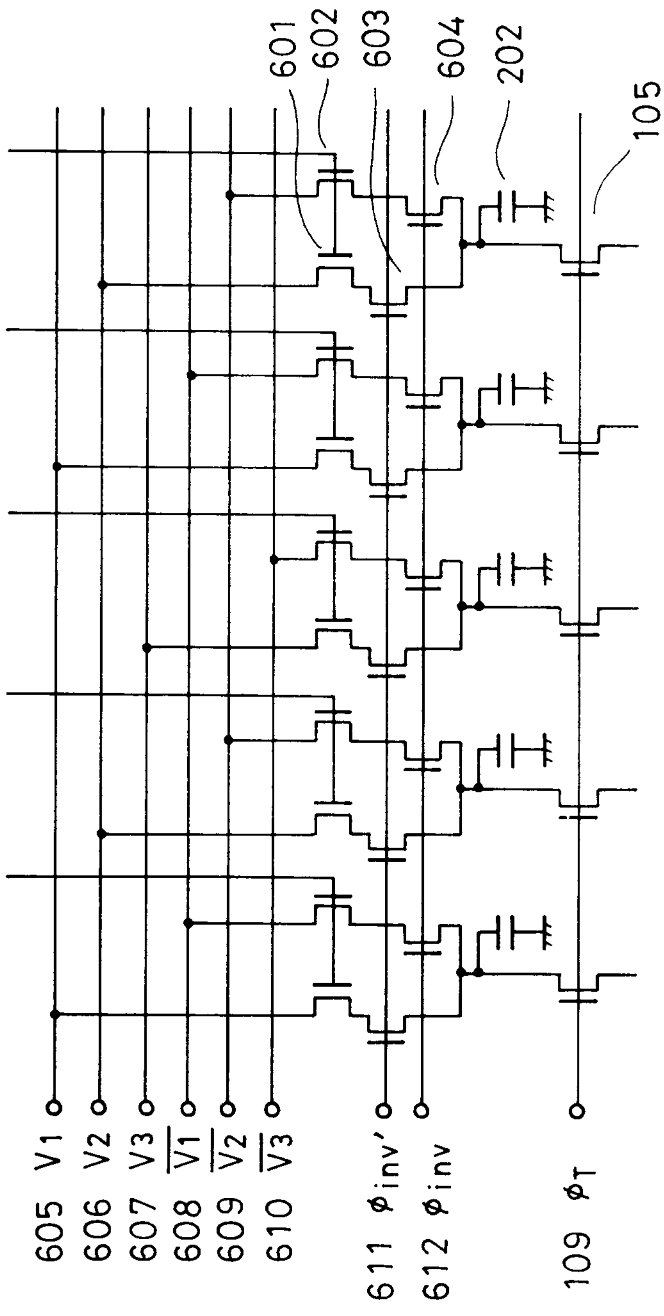
605 V1
606 V2
607 V3
608 $\overline{V1}$
609 $\overline{V2}$
610 $\overline{V3}$
611 $\phi_{inv}'$
612 $\phi_{inv}$
109 $\phi_T$
601
602
603
604
202
105

FIG. 29

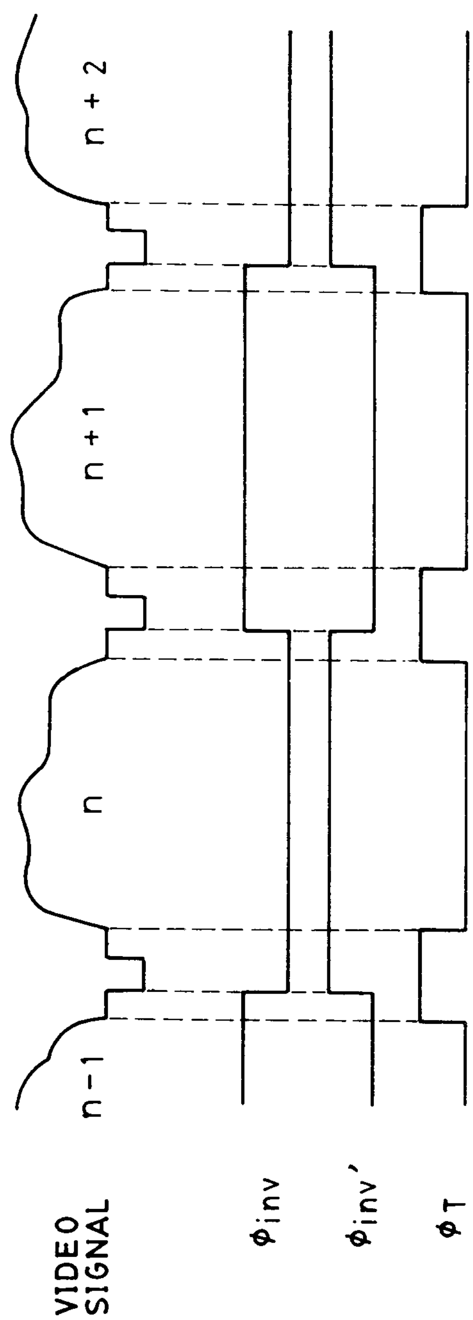

FIG. 30

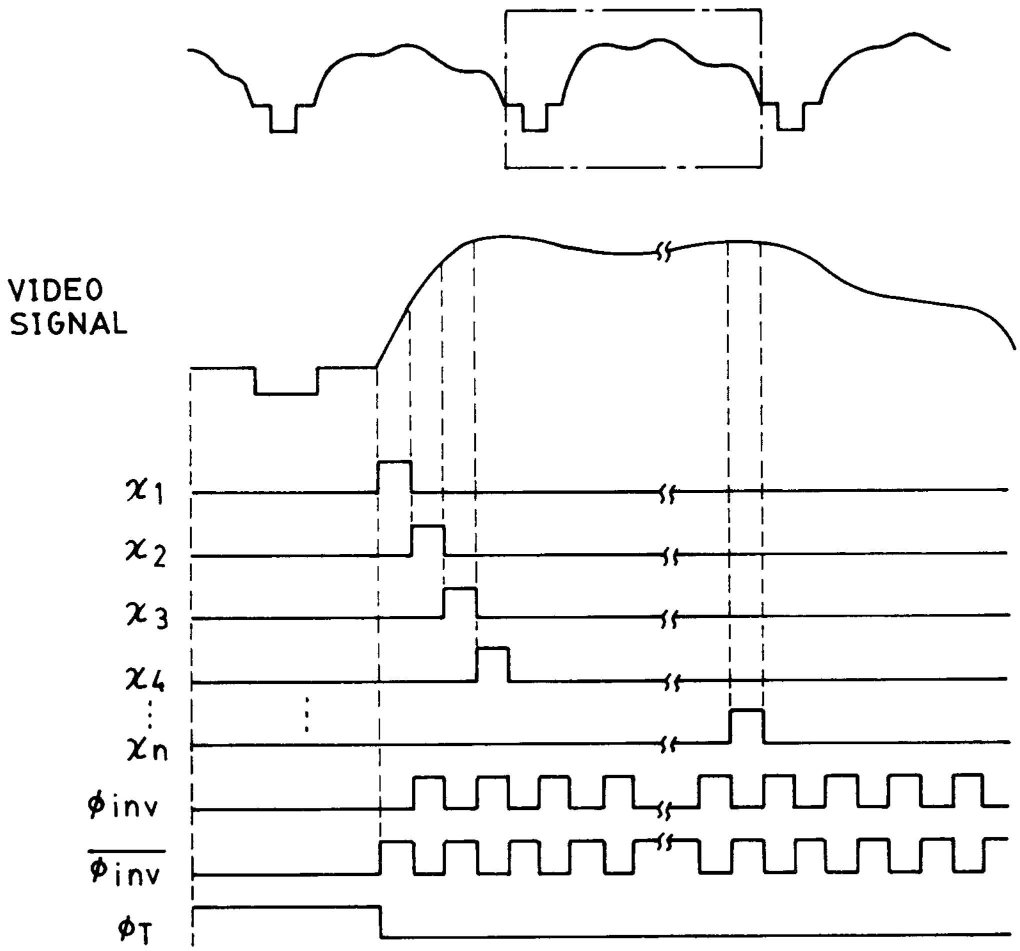

European Patent Office

# EUROPEAN SEARCH REPORT

Application Number

EP 93 30 0558

[redacted]

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X<br>Y<br><br>A | EP-A-0 268 380 (NEC CORPORATION)<br>* the whole document *<br>--- | 22,23,27<br>24,25,<br>28-30<br>1-21,26,<br>35 | G09G3/36<br>H01L21/76 |
| Y<br><br>A | EP-A-0 320 562 (STANLEY ELECTRIC CO., LTD)<br><br>* the whole document *<br>--- | 24,25,<br>28-30<br>26,27 | |
| X<br><br><br><br>Y | PATENT ABSTRACTS OF JAPAN<br>vol. 4, no. 36 (E-003)26 March 1980<br>& JP-A-55 008 158 ( SEIKO EPSON CORP )<br>* abstract *<br><br>--- | 31,32<br><br><br><br>33,34 | |
| Y | PATENT ABSTRACTS OF JAPAN<br>vol. 15, no. 495 (P-1288)13 December 1991<br>& JP-A-32 14 499 ( HITACHI LTD )<br>* abstract *<br>--- | 33-34 | |
| A | EP-A-0 449 589 (CANON KABUSHIKI KAISHA)<br>* abstract *<br>--- | 1-30,35 | TECHNICAL FIELDS SEARCHED (Int. Cl.5) |
| A | PATENT ABSTRACTS OF JAPAN<br>vol. 15, no. 287 (P-1229)22 July 1991<br>& JP-A-31 00 516 ( SHARP CORP )<br>* abstract *<br>--- | 1-30,35 | G09G<br>H01L<br>G02F |
| A | PATENT ABSTRACTS OF JAPAN<br>vol. 13, no. 228 (P-877)26 May 1989<br>& JP-A-10 38 727 ( NEC CORP )<br>* abstract *<br>--- | 1-30,35 | |
| A | PATENT ABSTRACTS OF JAPAN<br>vol. 11, no. 378 (P-645)10 December 1287<br>& JP-A-62 148 928 ( SEIKO EPSON CORP )<br>* abstract *<br>----- | 1-30,35 | |

The present search report has been drawn up for all claims

| Place of search | Date of completion of the search | Examiner |
|---|---|---|
| THE HAGUE | 14 MAY 1993 | ONSHAGE A.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)